# EUROPÄISCHE PATENTANMELDUNG

(11) **EP 3 056 341 A1**
(43) Veröffentlichungstag der Anmeldung: **17.08.2016**
(21) Anmeldenummer: 16151898.0
(22) Anmeldetag: 19.01.2016
(51) Int. Cl.: B32B 27/08, B32B 27/30, B32B 27/32, B32B 27/34, B32B 27/36, B32B 27/40, B32B 17/10

(54) **EINRICHTUNG MIT IR-REFLEKTIERENDER BESCHICHTUNG**

(30) Priorität: 11.02.2015 DE 102015001668
(71) Anmelder: Schott AG, 55122 Mainz (DE)
(72) Erfinder: APITZ, Dirk, 1012 Lousanne (CH); Walther, Marten, 31061 Alfeld (DE)
(74) Vertreter: Sawodny, Michael-Wolfgang

(57) **Zusammenfassung**

Einrichtung, insbesondere für Anzeigevorrichtungen, umfassend ein erstes scheibenförmiges Element und ein zweites scheibenförmiges Element, wenigstens eine zwischen dem ersten und dem zweiten scheibenförmigen Element eingebrachte IR-reflektierende Beschichtung und ein zwischen dem ersten und dem zweiten scheibenförmigen Element eingebrachtes Füllmaterial, wobei das erste und das zweite scheibenförmige Element, die IR-reflektierende Beschichtung und das Füllmaterial einen Verbund ausbilden, und eine Entspiegelungsbeschichtung, insbesondere im sichtbaren Wellenlängenbereich, auf der Außenseite des ersten oder der Außenseite des ersten und des zweiten scheibenförmigen Elements, aufgebracht ist, dadurch gekennzeichnet, dass das Füllmaterial aus wenigstens zwei Laminierfolien, wenigstens einer ersten Laminierfolie und einer zweiten Laminierfolie sowie wenigstens einer weiteren Folie umfasst, wobei wenigstens eine IR-reflektierende Beschichtung vorgesehen ist, wobei die IR-reflektierende Beschichtung auf die Folie aufgetragen ist, wobei die Folie zwischen die wenigstens erste und die zweite Laminierfolie eingebracht ist und die IR-Sonnenreflektivität im Wellenlängenbereich 780 nm bis 3000 nm der Einrichtung im Bereich 45% bis 95% liegt und die Reflektivität Rᵥᵢₛ im visuellen Wellenlängenbereich 400 nm bis 780 nm kleiner gleich 4% ist, bevorzugt im Bereich 0 % bis 4 % liegt.

## Beschreibung

Die vorliegende Erfindung betrifft eine Einrichtung mit IR-reflektierender Beschichtung, insbesondere für Anzeigevorrichtungen, Architekturanwendungen, Windschutzscheiben mit wenigstens einem ersten scheibenförmigen Element und einem zweiten scheibenförmigen Element und einer zwischen dem ersten und zweiten scheibenförmigen Element eingebrachten Beschichtung.

Insbesondere bei Anzeigevorrichtungen, die bevorzugt im Außenbereich Anwendung finden, und bei denen Sonnenlicht direkt auf die Anzeigeeinrichtung fällt ergibt sich das Problem, dass die Anzeigevorrichtungen mit Hilfe aufwändiger Kühlaggregate gekühlt werden müssen, um ein unzulässiges Aufheizen derselben zu verhindern. Dies ist insbesondere dann problematisch, wenn die Anzeigevorrichtungen im Außenbereich hoher Sonneneinstrahlung ausgesetzt sind. Anzeigevorrichtungen können beispielsweise Displays umfassen. Für das Aufheizen durch Sonneneinstrahlung ist das gesamte Spektrum mit Wellenlängen im Bereich 100 nm bis circa 3000 nm relevant. Im Allgemeinen wird versucht das Display selber durch eine aktive Kühlung zwischen der Frontscheibe und des Displays zu erreichen. Gerade in Gegenden mit hoher Sonneneinstrahlung führt die Gesamtstrahlung zu einer sehr starken Aufheizung von Anzeigevorrichtung durch Lichteinstrahlung. Insbesondere wenn Sonneneinstrahlung nicht ausreichend vermieden werden kann, kann sich das Display oberhalb seiner maximal zulässigen Arbeitstemperatur aufheizen. Dies bewirkt, dass das Display schwarz wird und nicht mehr lesbar ist.

Hohe Sonneneinstrahlung ist aber auch bei anderen Anwendungen problematisch, z.B. bei Einrichtungen, die als Verglasungen beispielsweise bei Gebäuden z.B. im Architekturbereich Verwendung finden. Hier soll insbesondere vermieden werden, dass durch Sonneneinstrahlung ein Gebäude aufgeheizt wird. Ein weiteres Anwendungsgebiet wäre die Einrichtung als Windschutzscheibe einzusetzen.

Idealerweise muss das Spektrum selektiv in verschiedene Wellenlängenbereiche aufgeteilt werden. Mit einem Energieeintrag des Sonnenlichts im UV-Bereich von 100 nm bis 400 nm, bei dem eine Transmission der elektromagnetischen Strahlung von 0 % ideal gefordert ist, im sichtbaren Spektralbereich von 380 nm bis 780 nm, bei dem eine Transmission der elektromagnetischen Strahlung möglichst groß, idealerweise 100% und eine möglichst kleinen Reflexion idealerweise 0% ist und im Infrarot- (IR-) Bereich von 700 nm bis 3000 nm, bei dem eine möglichst niedrige Transmission der elektromagnetischen Strahlung von Werten Richtung 0% und eine möglichst hohe Reflektion, im Idealfall von 100%, gefordert ist. In realer Anwendung trägt der UV-Bereich kaum zur Aufheizung bei, da nur geringe Energiemengen im Sonnenspektrum enthalten sind. Für den sichtbaren Bereich von 380 nm bis 780 nm sollten Transmissionen >70% und Reflektiviäten Rᵥᵢₛ kleiner 3% erreicht werden. Im Bereich 780 nm bis ca. 3000 nm sollte eine hohe Reflektivität größer 40% bei gleichzeitig sehr geringer Transmission von kleiner 10% erreicht werden, damit ein wirksamer Sonnenschutz erreicht wird, bei gleichzeitiger Steigerung des optischen Kontrastes der Displayeinrichtung durch niedrige optische Restreflektivität.

Verschiedene Lösungen zur Verminderung der Reflexion im IR-Bereich sind bekannt geworden, erfüllen aber nicht die gewünschten Werte.

Aus der US 2009/0237782 A1 ist eine Verbundglasscheibe mit einer IR-reflektiven Schicht bekannt geworden, insbesondere für großflächige Verglasungen.

Die DE-A-15 96 810 zeigt eine großflächige Verglasung mit einer Metallschicht, insbesondere einer Gold- oder Kupferschicht, die Infrarotstrahlung und langwelliges Licht reflektiert.

Aus der DE-C-199 27 683 ist eine Sonnen- und Wärmestrahlen reflektierende Verbundglasscheibe bekannt geworden.

Die DE-A-195 03 510 zeigt ein Verfahren zur Herstellung einer IR-reflektierenden Verbundglasscheibe.

Die DE-A-196 44 004 zeigt eine Wärmestrahlen reflektierende Verbundglasscheibe für Kraftfahrzeuge.

Die DE-T-694 30 986 zeigt ein Lichtventil mit einem Überzug niedrigen Emissionsvermögens als Elektrode.

Anzeigeeinrichtungen sind aus der DE-A-28 24 195 oder der JP-A-2006-162890 bekannt geworden.

Davon ausgehend ist die DE-A-10 2009 051 116 bekannt geworden. Sie beschreibt eine Einrichtung in Form eines Verbundglases mit zwei scheibenförmigen Elementen und einer zwischen diesen eingebrachten IR-reflektierenden Beschichtung, wobei diese in der Regel unmittelbar auf eines der scheibenförmigen Elemente aufgebracht wird. Weiterhin kann diese Einrichtung an einer oder beiden Außenflächen eine Entspiegelungsschicht und im Verbund innen liegend, ergänzend zu der IR-reflektierenden Beschichtung, Anpassungsschichten zur Optimierung der optischen Wirkung der Einrichtung aufweisen. Nachteilig hierbei ist ein aufwendiges Herstellverfahren, bei dem Festmaße verarbeitet werden müssen und so die Flächenausnutzung in der low-E Sputteranlage stark herabgesetzt ist und welches nur batchweise möglich ist. Low-E (aus dem Englischen "low emissivity") bedeutet dabei, dass eine Oberfläche einen geringen Emissionsgrad (im IR) hat, wie z. B. polierte Metalloberflächen. Diese Eigenschaft geht typischer Weise mit einer hohen Reflektivität (im IR) einher. Im Besonderen gilt die Beschränkung auf Festmaße bei der Verarbeitung von chemisch oder thermisch gehärteten Gläsern, die prinzipbedingt immer als Endformat vorliegen müssen. Auch eine Verarbeitung von gebogenen Gläsern ist nicht möglich. Da die optischen Eigenschaften der Low-E Schichten gegenüber den Standardschichten geändert werden müssen, aufgrund der beiden symmetrischen Grenzflächen im Verbund, muss der Prozess komplex neu eingefahren werden, so dass hier nur eine Kampagnenfertigung möglich ist. Alternativ kann man Lagermaße für Verbunde mit den äußeren AR und einer inneren IR-Schutz beschichten, allerdings ist dann ein hoher logistischer und Schutz-Aufwand zu treiben, da die IR-Schutzschichten schnell korrodieren und weich sind.

Aus der DE-A- 39 41 046 ist eine wärmereflektierende Glasplatte mit Mehrschicht-Belag bekannt geworden. Der Mehrschichtbelag besteht aus einem auf der Glasplatte abgeschiedenen Film aus Indium/Zinn-Oxid (ITO) oder AIN, einer wärmereflektierenden Schicht aus Ag oder Cu, die auf der Grundschicht mit einer Dicke von 4 bis 20 mm (40 bis 200 A) abgeschieden ist, einer Schicht aus metallischem Zn auf der Reflexionsschicht mit einer Dicke von 2 bis 20 mm (20 bis 200 A) und einer äußeren Schutzschicht, wieder aus ITO oder AIN. Die Abfolge der Reflexions-, Sperr- und äußerer Schutzschicht können mehrmals hintereinander überdeckend aufgebracht werden, so dass jede Reflexionsschicht aus Ag oder Cu durch eine Sperrschicht aus Zn und diese wieder durch eine Schutzschicht aus ITO oder AIN überdeckt werden. Durch den Mehrschichtbelag ergibt sich gemäß der DE-A- 39 41 046 eine erhöhte Feuchtigkeitsfestigkeit.

Die US 2009/0237782 A1 zeigt ein Substrat, das im nahen Infrarot reflektiert. Das aus der US 2009/0237782 A1 bekannte Substrat auf das die IR reflektierende Beschichtung aufgebracht wird, kann eine Glasplatte oder ein transparentes Polymer sein. Des Weiteren zeigt US 2009/0237782 A1 ein laminiertes Glas mit zwei Glasscheiben, wobei zwischen die beiden Glasscheiben zwei Folien, beispielsweise eine PVB-Folie sowie ein Substrat mit IR reflektierender Beschichtung eingebracht wird. Allerdings sind in der US 2009/0237782 A1 keine Angaben zur Höhe der IR-Sonnenreflektivität oder zur Reflektivität Rᵥᵢₛ im sichtbaren Wellenlängenbereich gemacht.

Aus der DE-C-199 27 683 ist eine Sonnen- und Wärmestrahlen reflektierende Verbundglasscheibe bekannt geworden. Die Verbundglasscheibe gemäß der DE-C-199 27 683 weist die Sonnenschutzschicht auf einer innerhalb des Verbundes liegenden Oberfläche der äußeren Glasscheibe auf.

Aufgabe der Erfindung ist es somit, eine Einrichtung für unterschiedlichste Anwendungen zur Verfügung zu stellen, die die Nachteile des Standes der Technik vermeidet und bei einer hohen Schutzwirkung gegen Sonnenlichteinstrahlung insbesondere für Anzeigevorrichtungen, oder Architekturanwendungen oder als Windschutzscheibe ein preiswertes und flexibles Herstellen mit weniger Aufwand ermöglicht.

Die Erfindung löst diese Aufgabe mit den Merkmalen des Anspruches 1.

Weitere vorteilhafte Ausgestaltungen der Erfindung sind in den abhängigen Ansprüchen 2 bis 15 beschrieben. Desweiteren stellt die Erfindung Verwendungen der Einrichtung sowie Vorrichtungen wie insbesondere Anzeige-Vorrichtungen und Touch Screens mit erfindungsgemäßen Aufbau zur Verfügung gemäß den Ansprüchen 16 bis 19.

Erfindungsgemäß umfasst die Einrichtung ein erstes scheibenförmiges Element und ein zweites scheibenförmiges Element, wobei eine IR-reflektierende Beschichtung zwischen dem ersten und dem zweiten scheibenförmige Element eingebracht wird. Weiterhin ist zwischen dem ersten und dem zweiten scheibenförmigen Element ein Füllmaterial und wenigstens eine Folie eingebracht. Bevorzugt umfasst das Füllmaterial wenigstens zwei Folien. Diese Folien können Laminierfolien oder Trägerfolien sein. Laminierfolien verflüssigen sich unter Druck bei Laminierbedingungen unterhalb von 200° C und verbinden sich klebend. Trägerfolien dagegen weisen eine derartige Eigenschaft nicht auf, so dass durch Trägerfolien in der Regel kein Verbund im Sinne eines Verbundssicherheitsglases hergestellt werden kann. Ein Glas ohne diese Sicherheitsmerkmale kann ebenfalls für derartige Displays eingesetzt werden, da die wärmeoptische Funktion hiervon unberührt ist. Die wenigstens eine Folie, die die IR-refklektierende Beschichtung oder die IR-reflektierenden Beschichtungen tragen kann, kann eine Polymerfolie, aber auch ein Glassubstrat sein. Generell kann die Folie, eine Folie aus organischem Material wie einer Polymerfolie oder einem anorganischen Material, beispielsweise eine Glasfolie bzw. eine glasartigen Folie aus einem Dünnglas wie beispielsweise dem Glas AF32 oder D263 der SCHOTT AG, Mainz, bestehen. Alternativ zum Dünnglas kann auch ultradünnes Glas, wie es von der SCHOTT AG, Mainz, angeboten wird, verwandt werden, das nicht nur flexibel, sondern auch rollbar ist. Der Offenbarungsgehalt der offiziellen Webside der SCHOTT AG, www.schott.com/advancedoptics/german/products/wafers-and thin glass/index.htm, die diese Gläser zeigt und beschreibt, wird in vorliegende Anmeldung vollumfänglich mit aufgenommen. Für den beschriebenen Anwendungsfall ist die Flexibilität der Polymerfolie oder Glasfolie keine zwingende Eigenschaft. Selbst Gläser mit 2 mm Dicke weisen eine ausreichene Flexibilität für den beschriebenen Anwendungsfall auf. Das erste und das zweite scheibenförmige Element, die IR-reflektierende Beschichtung und das Füllmaterial bilden einen Verbund aus. Der Raum zwischen den Scheiben ist mit dem Füllmaterial in Form von Folien ausgefüllt. Das Füllmaterial ist also nicht gasförmig, wie bei Isolierglasverbunden. Weiterhin ist eine Entspiegelungsbeschichtung, insbesondere im sichtbaren Wellenlängenbereich, jeweils auf der Außenseite des ersten und des zweiten scheibenförmigen Elements aufgebracht. Wie oben beschrieben ist die IR-reflektierende Beschichtung auf die weitere Folie oder zumindest auf einen Teilbereich der weiteren Folien aufgetragen. Die IR-Sonnenreflektivität der Einrichtung liegt im Wellenlängenbereich 780 nm bis 2500 nm im Bereich 30% bis 95%, bevorzugt im Bereich 50% bis 80% und die Reflektivität Rᵥᵢₛ im visuellen Wellenlängenbereich 400 nm bis 780 nm liegt im Bereich kleiner gleich 4%, bevorzugt kleiner gleich 3%, und gleichzeitig durch die Absorption in den Low-E Schichten die Energietransmission für Sonnenlicht im Bereich 380 nm bis 3000 nm gemittelt unterhalb von 45%, bevorzugt unterhalb 40% liegt.

Die erfindungsgemäße Ausgestaltung hat gegenüber der Ausgestaltung, die in der DE-B-10 2009 051 116.4 oder der WO 2011/050908 beschrieben sind, den Vorteil, dass die Folie mit IR-reflektierender Beschichtung sehr einfach hergestellt werden können. Das Einbringen zwischen zwei Folien, insbesondere Laminierfolien, z.B. zwei PVB-Folien hat zum einen den Vorteil eines sicheren Einschlusses der aufgebrachten IR-reflektierenden Beschichtung, die bevorzugt Silberschichten umfasst und daher zur Oxidation neigt, zum anderen können die Folien, insbesondere die Laminierfolien selbst so gewählt werden, dass keine Brechzahlsprünge bei den Übergängen vom Glas zur Laminierfolie und dann zur Folie mit wenigsten einer aufgebrauchten IR-reflektierenden Beschichtung auftreten. Besonders bevorzugt ist es, wenn die Folie mit IR-reflektierender Beschichtung zwischen zwei Laminierfolien in Form eines Sandwich eingebracht wird. Die Folie, auf die die IR-reflektierende Folie aufgebracht wird, hat bevorzugt eine Dicke, die zwischen 10µm und 5mm liegt. Die Laminierfolien stellen gemäß der Erfindung einen Korrosionsschutz zur Verfügung.

Der erfindungsgemäße Aufbau hat Vorteile bei der Herstellung von Einrichtungen mit IR-reflektierender Beschichtung. Ein Vorteil ist, dass die antireflektierenden Gläser nicht in die Anlage zur IR Beschichtung eingebracht werden müssen, da die IR Schicht auf einem folienartigen Substrat getrennt aufgebracht wird und der Verbund erst später zusammengefügt wird. Bei beispielhaften Anlagen zur IR Beschichtung, die beispielsweise Sputteranlagen sind, wird das Glas auf der Unterseite transportiert, wobei die Unterseite die antireflektierende Schicht bereits umfasst. Ein Rollentransport bei einem bereits beschichtetem Glas in der Anlage birgt aber die verstärkte Gefahr der Verkratzung der antireflektierenden Schicht, da die Anlagen oft nicht speziell auf diese empfindlichen Schichten ausgelegt sind.

Die mögliche Trennung der Prozesse bei dem erfindungsgemäßen Schichtaufbau hat den weiteren Vorteil, dass die mit einer antireflektierenden Beschichtung beschichtete Glasscheibe, sowie die mit einer IR-reflektierenden Beschichtung beschichtete Folien separat in anlagentechnisch optimierten Formaten bereitgestellt und gelagert werden können. Da die Vorprodukte getrennt hergestellt werden und nur der Laminierschritt beim Zusammenfügen der Vorprodukte zum Endprodukt das kundenspezifische Format haben muss, wird die Herstellung und Lagerung stark vereinfacht.

Die WO-A-2011/050908 zeigt zwar eine IR-reflektierende Beschichtung, die auf eine Folie aufgebracht ist, aber nicht die erfindungsgemäße Sandwich-Struktur, die eine getrennte Herstellung einzelner Vorprodukte ermöglicht.

Ein erfindungsgemäßer Verbund ermöglicht es, dass IR-reflektierende Beschichtungen, beispielsweise basierend auf Multischichtsystemen, die Metall-, insbesondere Silberschichten enthalten, sogenannte low-E-Beschichtungen, eingesetzt werden können, die eine sehr hohe Reflektivität im Bereich der IR-Strahlung von 780 nm bis 2000 nm, bevorzugt eine Reflektivität > 50 % im Wellenlängenbereich von 900 nm bis 1400 nm besitzen. Die eingesetzten IR-reflektierenden Schichten nehmen beginnend ab 700 nm immer mehr Reflektivität auf, d.h. eine Reflektion findet auch im fernen Infrarot statt. Bevorzugt umfassen die IR- reflektierenden Schichten ein Metall, insbesondere Silber. Derartige Schichten haben eine breitbandige Reflektivität im Infraroten, die sich weit über 1400nm ins Infrarote hinaus erstreckt.. Es handelt sich somit um Filter mit hoher Reflektivität überwiegend im Bereich des nahen Infraroten..

Unter transparenten Elementen oder Schichten werden insbesondere Schichten beziehungsweise Gläser mit einer Transmission größer gleich 50 Prozent bevorzugt > 70 % im sichtbaren Wellenlängenbereich von 380 nm bis 780 nm, bevorzugt von 400nm bis 780nm insbesondere von 420 nm bis 740 nm verstanden.

Dadurch, dass die IR-reflektierende Beschichtung, zwischen die Laminierfolien eingebracht wird, ist es möglich, hocheffiziente, aber korrosionsanfällige und/oder nicht kratzbeständige Silber-Ein- oder Mehrfachschicht-Systeme als IR-reflektierende Beschichtungen einzusetzen und gegen einen chemischen oder mechanischen Angriff, speziell Oxidation zu schützen. Hierfür kann z. B. nur am Rand eine Zone von kleiner 5 mm umlaufend vorhanden sein, in der keine IR-SchutzBeschichtung vorhanden ist, und letztere bei der Herstellung des Verbundes hermetisch abgeschlossen wird. Die IR-reflektierende Beschichtung kann durch einen Rand oder eine Randentschichtung und/oder ein Rückschneiden vor Korrosion geschützt werden, was insbesondere bei IR-reflektierenden Schichten, die Silber umfassen wichtig ist. Durch einen Rand oder einer Randentschichtung und/oder Rückschneiden wird vermieden, dass die laminierte Folie mit der IR-reflektierenden Beschichtung, insbesondere den Metallschichten, bevorzugt den Silberschichten seitlich offen lieg und somit angegriffen werden können. Gemäß der vorliegenden Erfindung werden die erste und zweite Laminierfolie, zwischen denen die Folie mit der IR-reflektierenden Beschichtung angeordnet ist, als Korrosionsschutz für die IR-Beschichtung verwandt. Die aus der DE-A-10 2009 051 116 und der US 2009/0237 782 A1 bekannten Laminate dienen dagegen nicht als Korrosionsschutz, insbesondere für eine IR-reflektierende Beschichtung sondern dazu mechanische Stabilität für den Verbund zur Verfügung zu stellen.

Alternativ oder zusätzlich kann der Außenbereich des Verbundes, an dem die Folien Luftkontakt haben, mit einer hermetischen Versiegelung versehen werden z.B. durch Butylkautschuk wie in Isolierverglasungen der Fensterindustrie, oder durch einen diffusionshemmenden Metallverbund. Diese Lösung führt in der Regel aber zu ästhetisch nicht befriedigendem Aussehen der Verglasung, so dass eine nicht beschichtete Randzone meist die Lösung ist.

Derartige, hochreflektive IR-Beschichtungen basierend auf Silberschichten werden als sogenannte "Soft-Coatings" bezeichnet und sind beispielsweise sehr eingehend in "Hans-Joachim Gläser, Dünnfilmtechnologie auf Flachglas, S. 167 - 171" beschrieben. Der Offenbarungsgehalt dieser Schrift wird in die vorliegende Anmeldung vollumfänglich mit aufgenommen. Um die Korrosionsanfälligkeit der zwischen dem ersten scheibenförmigen Element und dem zweiten scheibenförmigen Element eingebrachten Beschichtung zu minimieren, ist vorteilhafterweise vorgesehen, dass der Rand des ersten scheibenförmigen Elementes und/oder des zweiten scheibenförmigen Elementes keine IR-reflektierende Beschichtung aufweist. Besonders bevorzugt ist es, wenn die IR-reflektierende Beschichtung eine sehr hohe Reflektivität im Wellenlängenbereich von 780 nm bis 3000 nm aufweist. Im Idealfall würde die Reflektivität 100 % für Wellenlängen im Bereich von 780 nm bis 3000 nm betragen.

Nähert man die von der Sonne abgegebene Strahlung, also das Spektrum des Sonnenlichts, durch einen Planck'schen Strahler mit einer Temperatur T_{STRAHLER} = 5762 K an, so kann man ableiten, dass bei Vernachlässigung des UV-Anteils mit Wellenlängen < 380 nm ungefähr 55 % der Energie bzw. der Intensität des Sonnenlichtes im sichtbaren Wellenlängenbereich von 380 nm bis 780 nm liegt und ungefähr 45 % der Energie im IR-Wellenlängenbereich von 780 nm bis 3000 nm. Bei einem idealen IR-Spiegel mit einer Reflektivität von 100 % im Wellenlängenbereich von 780 nm bis 3000 nm würden somit 45 % des Sonnenlichts, nämlich der IR-Anteil reflektiert.

Um die Güte der Reflektivität der Beschichtung für IR-Strahlung anzugeben, wird in vorliegender Anmeldung die IR-Sonnenreflektivität definiert. Als IR-Sonnenreflektivität wird die spektrale Reflektivität der IR-Beschichtung im Wellenlängenbereich von 780 nm bis 3000 nm gefaltet mit der relativen Intensität des genäherten Spektrums des Sonnenlichts für einen Planck'schen Strahler mit einer Temperatur von 5762 K in dieser Anmeldung definiert. Während die IR-Sonnenreflektivität für Lösungen mit Folien gemäß dem Stand der Technik bei ungefähr 40 % liegt, zeichnen sich Systeme mit einer erfindungsgemäßen IR-Beschichtung durch eine IR-Sonnenreflektivität im Bereich von 45 % bis 95 %, bevorzugt von 50 % bis 90 % und durch eine die Reflektivität Rᵥᵢₛ im visuellen Wellenlängenbereich 380 nm bis 780 nm im Bereich kleiner gleich 4%, bevorzugt kleiner gleich 3% aus.

Die Laminierfolie und/oder die Folie, die die IR-reflektierende Beschichtung trägt und die zwischen die beiden Scheiben eingebracht wird, umfasst bevorzugt Polymermaterialien. Die Polymerfolie hat eine Transparenz größer 70%, bevorzugt größer gleich 85%, besonders bevorzugt größer gleich 88%, insbesondere bevorzugt größer gleich 92%. Beispielsweise weist eine Polymerfolie aus PMMA im angegebenen Dickenbereich eine Transparenz von größer/gleich 92% auf, eine Polymerfolie entsprechend aus PET von größer gleich 88% und eine Polymerfolie entsprechend aus PC von größer gleich 85%. Für andere Anwendungen außer einer in einer Anzeigevorrichtung, vor allem im Bereich Architektur und Möbel kann diese Folie aber auch farbig, transluzent oder opak gestaltet sein oder Träger von Bild oder Schrift sein.

Von der Erfindung umfasst werden auch IR-Beschichtungen, die statt auf eine Polymerfolie auf ein Glassubstrat aufgebracht werden, das dann wiederum durch Polymerfolien mit den antireflektierenden Schichten als Verbund mit drei Glasscheiben ausgebildet wird. In diesem Fall geht die Flexibilität der Folie mit der IR-Beschichtung verloren. Im Sinne der lichttechnischen Eigenschaften entsteht jedoch ein analoges Produkt zur Folie, das vollumfänglich vom Offenbarungsgehalt vorliegender Anmeldung umfasst wird.

Polymerfolien, auf die die IR-reflektierende Beschichtung aufgebracht wird (werden) haben bevorzugt, aber nicht ausschließlich, eine Dicke von kleiner gleich 400µm, bevorzugt kleiner gleich 200µm, besonders bevorzugt von kleiner gleich 50µm bis 20µm. Werden als Trägerfolie für die IR-Beschichtung PET-Folie eingesetzt, so liegt die Dicke zwischen 25-90µm, bevorzugt bei 60µm. Die Polymerfolie als Träger für IR-reflektierende Beschichtung besteht bevorzugt aus einem Polyethylenterephtalat (PET), Polycarbonat (PC), Polymethylmethacrylat (PMMA), Polyamid (PA), Polyimid (PI) oder einem Polyolefin wie Polyethylen (PE) oder Polypropylen, oder jeweils einem ihrer Blends, Copolymere oder Derivate oder aus einem fluorierten und/oder chlorierten Polymer, wie beispielsweise Ethylen-Tetrafluorethylen (ETFE), Polytetrafluorethylen (PTFE), Polyvinylchlorid (PVC), Polyvinylidenchlorid (PVdC) oder Polyvinylidenfluorid (PVDF). Auf diese Polymerfolie wird die IR-Beschichtung aufgetragen.

Die Laminierfolie ist ebenfalls eine Polymerfolie, insbesondere aus Polyvinylbutyral (PVB) oder Ethylenvinylacetat (EVA) oder Polyamid (PA) oder Polymethylmethacrylat (PMMA) oder Polyurethan (PUR). Vorzugsweise besitzt die Laminierfolie eine UV-Schutzwirkung, die Strahlung unterhalb 380 nm effektiv absorbiert. In besonderen Ausführungsformen sind dotierte Folien bekannt, bei denen auch bis 420 nm eine Schutzwirkung erreicht wird. Die Laminierfolien haben üblicherweise eine Dicke von 380µm oder 760µm. Die erforderliche Dicke der Laminierfolien kann variiert werden und an die statischen Erfordernisse des entstehenden Verbundes angepasst werden. Üblicherweise werden dafür mehrere Folien getrennt übereinandergelegt und in einem Schritt miteinander verbunden.

Die zuvor genannten Folien können zusätzlich zu der erfindungsgemäßen IR-Strahlung reflektierenden Beschichtung auch noch weitere Beschichtungen, beispielsweise auf Folie aufgebrachte weitere low-E-Schichten, wie eine Beschichtung aus mit Fluor dotiertem Zinnoxid umfassen. Solch eine low-E-Schicht kann aber in einer Alternative auch auf einer der im Verbund innen liegenden Oberfläche des ersten und/oder zweiten scheibenförmigen Elements aufgebracht sein. Solche Beschichtungen sind bekannt und werden beispielsweise mittels Sprühpyrolyse aufgetragen, wobei auf die Glasoberfläche, welche eine Temperatur im Bereich 400°C bis 650°C aufweist, eine pulverförmige Zinn- und Fluorverbindung, suspendiert in einem gasförmigen Trägerstrom, auf die Glasoberfläche aufgetragen wird und dort über Pyrolyse zu der gewünschten Wirkschicht reagiert.

Zur Herstellung des Verbundes beispielsweise mittels eines Polymermaterials, einer PVB-, EVA-, PA-, PMMA- oder PUR-Folie wird das Polymermaterial bzw. die Folie durch erhöhte Temperatur unter Druck verflüssigt oder erweicht und mit dem ersten scheibenförmigen Element und dem zweiten scheibenförmigen Element verklebt, ergebend den Verbund. Hierbei ist es bevorzugt, dass die IR-reflektierende Beschichtung direkt verklebt wird.

Die IR-reflektierende Beschichtung kann aus mindestens zwei Silberfunktionsschichten, vorzugsweise unterschiedlicher Dicke bestehen, die jeweils von dielektrischen Schichten eingeschlossen sind. Die IR-reflektierende Beschichtung wird erfindungsgemäß auf eine transparente Polymerfolie aufgetragen. Im Verbund wird die IR-reflektierende Beschichtung zwischen die thermoplastischen Laminierfolien eingelegt oder von diesen umschlossen. Es kann in einer Ausführung auch ein Vorverbund aus zwei oder mehr Folien hergestellt werden.

IR-reflektierende Beschichtungen sind beispielsweise auch low -E-Beschichtungen. Dies kann eine low-E-Beschichtung bestehend aus einer oder mehreren metallisch hochleitfähigen Schichten sein, beispielsweise basierend auf transparenten Metall-, insbesondere Silberschichten, die eine sehr hohe Reflektivität im Bereich der nahen IR-Strahlung im Wellenlängenbereich von 780 nm bis 3000 nm aufweisen. Neben einer low-E-Beschichtung basierend auf Silberschichten wie beispielsweise in Hans-Joachim Gläser, "Dünnfilmtechnologie auf Flachglas", Verlag Karl Hoffmann, 1999, S. 155 - 200 beziehungsweise 219 - 228 beschrieben, können auch andere Schichten mit sehr guter Leitfähigkeit angewendet werden. Beispiele hierfür sind Gold- oder Aluminiumschichten. Die Schichten können jeweils auch miteinander kombiniert werden.

Daneben kann die IR-reflektierende Beschichtung aber auch aus einem Metalloxid oder einer Kombination von Schichten aus verschiedenen Metalloxiden bestehen. Beispiele für solche Schichten sind Indiumzinnoxid (ITO) oder ein dotiertes Zinnoxid wie FTO (SnOx:F) oder ATO (SnOx:Sb) oder ein dotiertes Zinkoxide wie ZnOx:Ga, ZnOx:F, ZnOx:B oder ZnOx:Al. Der Auftrag solch einer Schicht oder Schichten auf das Füllmaterial oder gegebenenfalls auf die im Verbund innere Oberfläche eines scheibenförmigen Elements erfolgt vorzugsweise mittels Chemical Vapor Deposition (CVD) oder Physical Vapor Deposition (PVD), Tauchbeschichtung, chemisch oder elektrochemische Beschichtung. Nur beispielsweise seien hier die Sprühpyrolyse, das Sputtern oder Sol-Gel-Verfahren genannt. Das Auftragen mittels Sprühpyrolyse ist besonders kostengünstig, wobei als Beschichtungsmaterial bevorzugt SnOx:F verwendet wird. Will man besonders gute optische Eigenschaften erzielen, so ist das bevorzugte Auftragsverfahren das Sputtern. Speziell das Sputterverfahren hat sich als Standard etabliert, da es metallische Schichten mit sehr hoher Flächenleitfähigkeit ermöglicht. Eine hohe Flächenleitfähigkeit wiederum korreliert mit einer guten Reflexion im nahen Infrarot, speziell oberhalb 780nm. Des Weiteren ergibt sich eine Bandkante ohne dass der sichtbare Anteil zu stark beschränkt wird. Halbleitende Metalloxidschichten weisen ebenfalls das hier gewünschte Verhalten der hohen IR Reflexion bei gleichzeitiger guter Transmission im Sichtbaren auf.

In einer Ausführung der Erfindung umfasst die Einrichtung eine Kombination aus einer ersten und zweiten IR- reflektierenden Beschichtung. Die erste IR-reflektierende Beschichtung enthält zumindest eine oder zwei Metallschichten, bevorzugt Silberschichten und ist auf eine Folie, insbesondere eine Polymerfolie aufgetragen und besitzt im nahen IR eine steile Reflektivitätsflanke. Die zweite IR-reflektierende Beschichtung ist auf oder unter der ersten IR-reflektierenden Beschichtung auf der Folie aufgetragen oder auf einer weiteren Folie oder auf der im Verbund innen liegenden Oberfläche des ersten und/oder zweiten scheibenförmigen Elements aufgebracht und reflektiert im mittleren IR-Bereich. Beide IR-reflektierenden Beschichtungen zusammen bilden in dieser Ausführungsform die IR-reflektierenden Beschichtung im Sinne der Erfindung. Eine Kombination einer ersten und zweiten IR- reflektierenden Beschichtung bildet eine verstärkte IR- reflektierende Beschichtung im Sinne der Erfindung.

Besonders bevorzugt im Hinblick auf Korrosionsbeständigkeit ist es, wenn der Rand des ersten scheibenförmigen Elementes und des zweiten scheibenförmigen Elementes keine IR-reflektierende Beschichtung aufweist oder die IR-reflektierende Beschichtung am Rand unterbrochen ist und zum anderen der Rand ein Dichtmaterial umfasst. So wird die Beschichtung durch das Laminieren selbst von der Umgebungsatmosphäre isoliert und im einfachsten Fall ist das Dichtmaterial die Laminierfolie selber. Alternativ kann die Isolation bzw. Dichtung nach dem Verbinden von außen auf den Rand des Verbundes aufgebracht werden. In Fällen mit erhöhter Korrosionsbeständigkeit kann als mögliches Dichtmaterial beispielsweise Butylkautschuk verwendet werden, der sich durch geringe Gasdurchlässigkeit auszeichnet. Eine alternative Dichtungsmöglichkeit ist die Dichtung durch eine umlaufende Aluminiumfolie, die wiederum mit einem Kunststoff mit geringer Gasdurchlässigkeit verklebt wird.

Der Rand des ersten und/oder zweiten scheibenförmigen Elementes sollte so ausgestaltet sein, dass die aufgebrachten low-E Schichten nicht von der Seite des Verbundes her korrodieren. Als wirksames Mittel kann beispielsweise das Randendschichten eingesetzt werden, bei dem die Low -E Schicht nicht bis zum Rand durchgeht und so das Laminat am Rande direkt zwischen oberem und unterem Glas versiegelt werden kann.

Bevorzugt sind wenigstens 5 mm der Scheibe als Rand ausgebildet, in denen die IR-reflektierende Beschichtung unterbrochen ist bzw. der keine IR-reflektierende Beschichtung aufweist. Die Maximalgrenze des Randes wird so gewählt, dass der sichtbare Bereich für den Betrachter der Verbundglasscheibe nicht gestört wird. Um den Kontrast und damit die Anzeigequalität, insbesondere bei Verwendung des Glases im Anzeigebereich, d. h. für Anzeigevorrichtungen, zu erhöhen, ist vorgesehen, dass das auf der Außenseite des ersten oder der Außenseite des ersten und des zweiten scheibenförmigen Elements eine Entspiegelungs- oder Antireflexbeschichtung aufgetragen ist.

Durch das Beschichten wenigstens einer Oberfläche des Verbunds mit einer Entspiegelungsbeschichtung bzw. Antireflexbeschichtung wird insbesondere die Reflexion im sichtbaren Wellenlängenbereich von 350 nm bis 780 nm insbesondere 400 nm bis 780 nm, besonders bevorzugt 420 nm bis 720 nm einer Einrichtung deutlich vermindert und so der Kontrast von Anzeigeeinrichtungen gegenüber Einrichtungen ohne Entspiegelungsbeschichtung deutlich erhöht. Dieser Kontrast bezieht sich auf das Verhältnis des von einer Anzeigevorrichtung, beispielsweise eines Display, emittierten Lichtes in Bezug auf die von der Frontscheibe oder der Vorsatzscheibe reflektierte Strahlung des Umgebungslichtes vor einem vom Display als schwarz dargestellten Bereich. Bevorzugt wird der Reflexionsgrad Rᵥᵢₛ durch die Entspiegelungsbeschichtung um 50% bis 99% gegenüber einem nicht mit einer Entspiegelungsbeschichtung versehenen scheibenförmigen Element verringert. Beträgt der Reflexionsgrad Rᵥᵢₛ des scheibenförmigen Elementes ohne Entspiegelungsbeschichtung beispielsweise 8%, so kann durch die Entspiegelungsbeschichtung der Reflexionsgrad Rᵥᵢₛ auf 0,1% bis 6%, bevorzugt auf 0,1% bis 4% reduziert werden. Bei dem zuvor genannten Reflexionsgrad Rᵥᵢₛ handelt es sich um einen Reflexionsgrad bei Normlicht D65 (künstlichem Tageslicht), gefaltet mit der Augenempfindlichkeit. Obwohl die Reflexion für einzelne Wellenlängen größer als beispielsweise 2% sein kann, kann sich für das Normlicht D65 ein Wert Rᵥᵢₛ von 1% oder geringer ergeben.

Durch die Verminderung der Reflexion an der Oberfläche des Verbundes bedingt durch die Antireflexbeschichtung bzw. Entspiegelungsbeschichtung sowie innerhalb des Verbundes durch die low-E-Schicht und gegebenenfalls Anpassungsschichten wird der Kontrast gegenüber einem nicht mit einer Entspiegelungsbeschichtung versehenen Element deutlich erhöht. Als Entspiegelungsbeschichtungen werden bevorzugt Interferenzschichtsysteme eingesetzt. Bei solchen Systemen wird an den Grenzflächen der Entspiegelungsbeschichtung Licht reflektiert. Die an den Grenzflächen reflektierten Wellen können sich durch Interferenz sogar völlig auslöschen, wenn Phasen- als auch Amplitudenbedingung erfüllt sind.

Derartige Entspiegelungsbeschichtungen sind beispielsweise in den Produkten AMIRAN, CONTURAN, oder MIROGARD der Schott AG realisiert. Betreffend ein Interferenz-Schichtsystem für breitbandige Entspiegelung wird auch auf die EP-A-1248959 verwiesen, deren Offenbarungsgehalt vollumfänglich in die vorliegende Anmeldung mit aufgenommen wird.

Neben der Verminderung der Reflexion Rᵥᵢₛ im optisch sichtbaren Spektralbereich 380nm bis 780nm kann durch die Entspiegelungsbeschichtung auch eine Erhöhung der Transmission bevorzugt um bis zu 10% erreicht werden.

Die Entspiegelungs- oder Antireflexbeschichtung wird bevorzugt auf einer nach außen, d.h. zur Luft hin gerichteten Seite des ersten und/oder des zweiten scheibenförmigen Elementes vorgesehen. Ein Aufbringen einer Entspiegelungsschicht auf der nach außen, d.h. zur Luft hin gerichteten Seite des ersten und/oder zweiten scheibenförmigen Elementes ist aus der US 2009/0237782 A1 nicht bekannt geworden.

Als Entspiegelungs- beziehungsweise Antireflexbeschichtungen kommen Schichten, die nach unterschiedlichen Verfahren hergestellt sind, in Betracht. Derartige Schichten können z. B. nach einem Sol-Gel-Verfahren, nach Sputterverfahren, nach Ätzverfahren oder in einem CVD-Verfahren hergestellt werden. Im Einzelnen kann die Entspiegelungsbeschichtung mit einem der nachfolgenden Auftragsverfahren aufgebracht werden:
a) Die Entspiegelungsbeschichtung wird mit Hilfe der Flüssigtechnologie aufgebracht, wobei die mit Hilfe der Flüssigtechnologien aufgebrachte Schicht mit Hilfe einer der nachfolgenden Techniken zur Verfügung gestellt wird:
   - die Entspiegelungsbeschichtung wird mit Hilfe der Sol-Gel-Technologie aufgebracht;
   - die Entspiegelungsbeschichtung wird als Einfachinterferenzbeschichtung aus der Sol-Gel-Technologie hergestellt;
   - die Entspiegelungsbeschichtung wird als Mehrfach-Interferenzbeschichtung aus der Sol-Gel-Technologie hergestellt;
   - die Entspiegelungsbeschichtung wird als Dreifach-Interferenz-Beschichtung aus der Sol-Gel-Technologie hergestellt, wobei die erste Schicht eine Brechzahl zwischen 1,6 und 1,8 aufweist, die zweite Schicht eine Brechzahl zwischen 1,9 und 2,5 aufweist und die Brechzahl der dritten Schicht zwischen 1,4 und 1,55 liegt.
b) die Entspiegelungsbeschichtung wird mit Hilfe einer Hochvakuumtechnologie hergestellt, wobei die mit Hilfe der Hochvakuumtechnologie aufgebrachte Schicht mit einer der nachfolgenden Techniken zur Verfügung gestellt wird:
   - die Entspiegelungsbeschichtung wird mit Hilfe einer Hochvakuumtechnologie als Mehrfach-Interferenzschichtsystem hergestellt;
   - die Entspiegelungsbeschichtung wird mit Hilfe einer Hochvakuumtechnologie als Einfachschichtsystem hergestellt;
   - die Entspiegelungsbeschichtung wird aus einem Sputterprozess unter Hochvakuum hergestellt;
   - die Entspiegelungsbeschichtung wird aus einem Aufdampfprozess unter Hochvakuum hergestellt.
c) die Entspiegelungsbeschichtung wird mit Hilfe eines CVD-Verfahrens hergestellt, wobei die mit Hilfe eines CVD-Verfahrens aufgebrachte Schicht mit einer der nachfolgenden Techniken zur Verfügung gestellt wird:
   - die Entspiegelungsbeschichtung wird aus einem Online-CVD-Prozess hergestellt;
   - die Entspiegelungsbeschichtung wird aus einem Offline-CVD-Prozess hergestellt.
d) die Entspiegelungsbeschichtung wird mit Hilfe eines Ätzverfahrens hergestellt, wobei die mit Hilfe eines Ätzverfahrens aufgebrachte Schicht mit einer der nachfolgenden Techniken zur Verfügung gestellt wird:
   - die Entspiegelungsbeschichtung wird mit Hilfe eines Ätzverfahrens als poröse Schicht hergestellt;
   - die Entspiegelungsbeschichtung wird mit Hilfe eines Ätzverfahrens als lichtstreuende Oberfläche hergestellt.

Um eine hohe IR-Reflexion und insbesondere eine IR-Sonnenreflektivität im Bereich 45 % bis 95 %, bevorzugt von 50 % bis 90 %, für das Gesamtsystem aus den beiden scheibenförmigen Elementen und der zwischen diesen eingebrachten festen und flüssigen Füllmaterialien zu erreichen, wird das low-E Beschichtungssystem, basierend auf mindestens einer Silberschicht zum Erreichen hoher IR-Reflexion, angepasst. Hierzu werden die Schichten, die das Silber umgeben so angepasst, dass die Entspiegelungswirkung an die Brechzahl des festen oder flüssigen Füllmaterials, insbesondere die Laminierfolie, z. B. der PVB-Folie angepasst ist. Beispielsweise kann eine derartige Brechzahlanpassung mit Kathodenzerstäubung erreicht werden. Beispielsweise weist die Kathodenzerstäubung eine Vielzahl von oxidischen Materialien auf, mithilfe derer eine derartige Anpassung durchgeführt werden kann. Als Basis der low-E-Beschichtungen kann beispielsweise die von der Fa. ARCON (Bucha, Feuchtwangen) hergestellten Sonnenschutzschichten Sunbelt Platin verwendet werden, die gemäß den oben angegebenen Regeln modifiziert, d. h. an die Brechzahl des festen oder flüssigen Füllmaterials, insbesondere der Folien, angepasst wird. Besonders bevorzugt sind Verfahren, bei denen die low-E Beschichtung bereits im Sputterverfahren auf die Folie, insbesondere die Polymerfolie des späteren Verbundes aufgetragen wird. Als Anbieter derartiger Schichten kann die Fa. Southwall benannt werden.

Insbesondere ist es durch Einbringen von optischen Anpassungsschichten, die bevorzugt oxidische und/oder oxidisch leitfähige Schichten umfassen möglich, dass die Reflektivität R_{Vis} der Einrichtung kleiner gleich 4%, insbesondere kleiner gleich 3% ist. Die Anpassungsschichten müssen optisch mit dem Schichtpakets einer metallischen Low-E-Beschichtung wirken, so dass sie vorzugsweise als gemeinsames Schichtpaket aufgetragen werden. Bei einer Trennung des Auftrages müssen beide Schichtpakete jedoch direkt übereinander liegen.

In einer weiteren Ausführung der Erfindung umfasst die Einrichtung zumindest eine, bevorzugt zwei strukturierte elektrisch leitfähige transparente Schichten einer TCO-Beschichtung. Diese leitfähige Schicht ist im sichtbaren Wellenlängenbereich transparent oder quasitransparent und beliebig strukturierbar. Die Strukturierung wird nach den Erfordernissen der Anwendung, beispielsweise als Sensor oder als Sensors und Treiber für ein Touchscreen ausgestaltet. Die TCO-Beschichtung besteht bevorzugt aus einem Metalloxid, insbesondere Indiumzinnoxid (ITO) oder aus einem dotierten Zinnoxid wie FTO (SnOx:F) oder ATO (SnOx:Sb). Denkbar sind aber auch dotierte Zinkoxide wie ZnOx:Ga, ZnOx:F, ZnOx:B oder ZnOx:Al. Der Auftrag dieser Schicht erfolgt vorzugsweise mittels Chemical Vapor Deposition (CVD) oder Physical Vapor Deposition (PVD), Tauchbeschichtung, chemisch oder elektrochemische Beschichtung. Nur beispielsweise seien hier die Sprühpyrolyse, das Sputtern oder Sol-Gel-Verfahren genannt. Das Auftragen mittels Sprühpyrolyse ist besonders kostengünstig, wobei als Beschichtungsmaterial bevorzugt SnOx:F verwendet wird. Will man besonders hohe optische Eigenschaften erzielen, so ist das bevorzugte Auftragsverfahren das Aufsputtern. Es kann aber auch Beschichtung aus einem Metall wie Silber, Gold oder Aluminium Anwendung finden.

Solch eine TCO Beschichtung, insbesondere ITO-Beschichtung wirkt zum einen als elektrische Leiterbahn, beispielsweise für einen Sensor, z.B. für einen kapazitiven Touchscreen. Zum anderen aber wirkt er im Sinne der Erfindung als IR reflektierende Beschichtung, insbesondere im Bereich des mittleren IR der Wellenlängen 2000 nm bis 10.000 nm. Eine vorstehend beschriebene IR reflektierende Beschichtung, enthaltend zumindest zwei Silberschichten, reflektiert vor allem im Bereich nahen Infrarot der Wellenlängen 780 nm bis 3000 nm. Eine Kombination beider Beschichtungen bildet eine verstärkte IR-reflektierende Beschichtung im Sinne der Erfindung.

Die TCO Beschichtung wird in einer Ausführung auf die im Verbund innere Oberfläche des ersten, d.h. dem Betrachter zugewandten, scheibenförmigen Elements aufgetragen. Bei der Verwendung der Beschichtung als Sensor besteht die Beschichtung aus zwei Schichten, welche durch eine transparente elektrische Isolation voneinander getrennt sind.

Aufgrund der Strukturierung einer TCO-Schicht sind beschichtete und nicht beschichtete Bereiche des Substrates auf dem die TCO-Schicht aufgetragen wurde im Kontakt zum nächsten Medium, d. h. die beiden die TCO-Schichten einschließenden Medien berühren sich in Bereichen, in denen die Struktur keine TCO-Schicht aufweist. Durch die Entspiegelungsschicht auf der Außenseite, d.h. der Luft zugewandten Seite des ersten scheibenförmigen Elements würde die Strukturierung besonders sichtbar werden. Erfindungsgemäß wird dies jedoch durch die Anpassungsschicht unterbunden. Es wird in Richtung IR-reflektierende Beschichtung auf der Folie auf die TCO-Schicht eine Anpassungsschicht aufgetragen, so dass die beiden möglichen Schichtfolgen (1) Folie - IR-Schutzschicht - Anpassungsschicht - TCO - nächstes Medium (z. B. Glas) und (2) Folie - IR-Schutzschicht - Anpassungsschicht - nächstes Medium (z. B. Glas) die gleichen visuellen Eigenschaften haben und somit die Struktur für TCO-Beschichtung dem menschlichen Auge nicht sichtbar sind.

In einer bevorzugten Ausführung der Erfindung wird diese Anpassungsschicht in den Schichtaufbau der IR-reflektierenden Beschichtung auf der Folie integriert, sodass die TCO-Struktur nicht sichtbar wird.

In einer weiteren Ausführungsform wird die TCO-Beschichtung, bzw. zwei elektrisch voneinander isolierte TCO-Schichten, auf die IR-reflektierende Beschichtung auf der Folie aufgebracht, wobei Anpassungsschichten in den Schichtaufbau der IR-reflektierenden Beschichtung auf der Folie integriert sind, sodass die TCO-Struktur nicht sichtbar wird. Für die Anwendung als Touch-Sensor muss die strukturierte TCO-Schicht in Richtung der zu berührenden Glasoberfläche gegenüber der Low-E Schicht liegen.

Alternative Konzepte wie Infrarot oder akustischer Oberflächenwellenleiter zur Realisierung des Touch Displays interagieren nicht mit den leitfähigen Metallschichten und können damit flexibel in das Gesamtsystem eingefügt werden.

Als Verwendung kommt für die Erfindung, die sich insbesondere dadurch auszeichnet, dass sie zum einen eine hohe IR-Sonnenreflektivität und zum anderen eine niedrige Reflektivität im visuellen Wellenlängenbereich aufweist, Verwendung im Bereich von Anzeigevorrichtungen, insbesondere Anzeigevorrichtungen im Außenbereich und hier bevorzugt Flüssigkeitsanzeigevorrichtungen in Betracht. Die Einrichtung kann als Bestandteil einer Anzeigevorrichtung, wie einem Display vorgesehen werden oder sie kann bevorzugt als Vorsatzscheibe auf eine Anzeigevorrichtung aufgebracht werden. In jedem Fall ist der Randbereich der Einrichtung versiegelt.

Bei Einsatz einer Entspiegelungsbeschichtung können störende Reflexionen vermieden werden, die den intrinsisch hohen Kontrast von LCD Anzeigen vermindern. Der Kontrast ist normalerweise als Quotient der maximalen und minimalen Leuchtdichte definiert. Bei schwarzer Schrift auf weißem Grund wäre das die Leuchtdichte des weißen Hintergrundes dividiert durch die Leuchtdichte der schwarzen Schrift. Im Fall eines Displays mit Vorsatzscheibe kommt die maximale Leuchtdichte von einem weißen Punkt auf dem Display und ist zusätzlich vom an den Oberflächen reflektierten Umgebungslicht überlagert. Die minimale Leuchtdichte kommt analog von einem schwarzen Punkt des Displays und ist mit reflektiertem Licht überlagert. Damit ist der Kontrast eines Displays abhängig von den umgebenden Lichtbedingungen. Alternativ ist es bevorzugt eine umgebungs- und displayunabhängige Kontrastwirkung - den sogenannten dynamischen Kontrast zu definieren, der nicht mehr die Umgebungseigenschaften einschließt.

Beispielsweise beträgt der dynamische Kontrast bei einem LED-Fernseher 2 000 000 : 1.

Der Einfluss von sehr gut entspiegelten erfindungsgemäßen Vorsatzscheiben soll an nachfolgenden Beispielen erläutert werden. Im ersten Fall wird die Wirkung für einen LED-Außenbildschirm mit einer Leuchtdichte von 5000 cd/m² bei einem mittleren bedeckten Himmel mit einer Leuchtdichte von 2000 cd/m² betrachtet.

Es ergibt sich dann ein Wert von 3 * 4% (Display-Oberfläche und frei stehende Vorsatzscheibe) je nicht-entspiegelt: (5000+2000*0.12)/(2000*0.12) = **20** charakteristisch für gute Lesbarkeit
und bei Einsatz einer erfindungsgemäßen entspiegelten Vorsatzschreibe.1 * 0.3% optisch gebondete und sehr gut entspiegelte Vorsatzscheibe: (5000+2000*0.003)/(2000*0.003) = **800** charakteristisch für hohen Kontrast.

Betrachtet man einen hellen TFT-Bildschirm mit 1200 cd/m² (Kontrast 700:1) bei klarem Himmel mit einer Leuchtdichte von 8000 cd/m² so ergibt sich ein Wert von 3 * 4% (Display-Oberfläche und frei stehende Vorsatzscheibe) nicht-entspiegelt: (1200+8000*0.12)/(8000*0.12+1200/700) = **2** was praktisch eine Nicht-Lesbarkeit bedeutet
und bei Verwendung einer erfindungsgemäßen Vorsatzschreibe
1 * 0.3% optisch gebondete und sehr gut entspiegelte Vorsatzscheibe: (1200+8000*0.003)/(8000*0.003+1200/700) = **50**, was eine Lesbarkeit ermöglicht. Dies bedeutet, dass eine gute Vorsatzscheibe mit einer Rᵥᵢₛ von ungefähr 0,3% für eine Spiegelseite bei einem guten TFT bei Sonnenschein den Unterschied zwischen einem praktisch nicht lesbaren und einem gut lesbaren Bildschirm ausmacht. Bei einem LED-Außen-Display besteht der Unterschied zwischen einem lesbaren und einem brillianten kontrastreichen Bild.

In einer speziell ausgebildeten Version zur weiteren Kontrasterhöhung kann die Vorsatzscheibe direkt mit dem Display verbunden werden, z. B. in dem man die Vorsatzscheibe direkt auf die Anzeigeeinrichtung bzw. das Display bondet. Im Fall einer direkt auf die Anzeigeeinrichtung gebondeten Vorsatzscheibe entfällt die rückseitige Antireflexschicht, aber bauartlich bedingt auch die Möglichkeit der Kühlung des Displays durch den Luft-Zwischenraum. Dieser Fall, der auch als optisches Bonding bezeichnet wird, stellt erhöhte Anforderungen an die Reflexion im Infraroten, da nur die Reflexion die Energie der einstrahlenden Sonne vermindert, während eine Absorption in dem Glas und den Schichten durch Wärmetransport an das Display weitertransportiert wird. Bei einem derartigen Aufbau beschriebene hohe IR-Reflektivität noch stärkere Bedeutung zu.

In einer Ausführung kann die Einrichtung als Touchscreen oder als Bestandteil eines Touchscreens verwendet werden. Neben der Verwendung der Einrichtung als Touchscreen stellt die Erfindung auch einen Touchscreen zur Verfügung, wobei die Einrichtung als kapazitiver und/oder optischer und/oder induktiver und/oder akustischer Touchscreen ausgeführt ist.

Hierbei umfasst die Einrichtung neben der IR-reflektierenden Beschichtung auch die Bestandteile zur Ausbildung der Funktionalität eines Touchscreens, welche wiederum auch Bestandteil der IR-reflektierenden Beschichtung sein können. Beispielsweise werden für einen projiziert-kapazitiven Touchscreen (PCT "projected capacitive touch") die strukturierten elektrisch leitfähigen Schichten zur Ausbildung eines Sensors und Treibers in der Einrichtung mit vorgesehen. Eine leitfähige Schicht dient hierbei als Sensor, die andere als Treiber, wobei beide Schichten voneinander isoliert sind. Gleichzeitig sind beide Schichten Bestandteil der IR-reflektierenden Beschichtung. Auch kann zur Ausbildung eines oberflächenkapazitiven Touchscreens eine transparente leitfähige Schicht, beispielsweise aus einem dotierten Metalloxid in der Einrichtung integriert sein. Die Schicht ist direkt auf die im Verbund innere Oberfläche des ersten scheibenförmigen Elements, welches dem Betrachter zugewandt ist, oder auf einem Füllmaterial, wie einer Polymerfolie, aufgetragen und einlaminiert. Gleichzeitig ist diese Schicht Bestandteil der IR-reflektierenden Beschichtung. Wenn die elektrisch leitfähigen Metall- oder Metalloxidschichten nur dünne Unterbrechungen durch die Elektrodenstrukturierung aufweisen, bleibt im Wesentlichen ein Großteil der Oberfläche mit hoher IR-Schutzwirkung gegenüber den nicht leitfähigen Schichten, und trotzdem kann an den strukturierten Bereichen die Touchfunktion elektrisch ausgewertet werden.

Vorzugsweise werden die Anpassungsschichten hierbei optisch derart angepasst, dass auch die Leitbahnstruktur des Touchscreens nicht oder nahezu nicht sichtbar ist und dass weiterhin die Reflektivität R_{Vis} der Einrichtung kleiner gleich 4%, insbesondere kleiner gleich 3% beträgt.

Neben der Einrichtung, insbesondere der Scheibe für eine Anzeigevorrichtung stellt die Erfindung auch eine Anzeigevorrichtung mit einem Display bzw. einer Displayvorrichtung und einer Vorsatzscheibe zur Verfügung, wobei die Vorsatzscheibe als erfindungsgemäße Einrichtung umfassend zwei scheibenförmige Elemente mit dazwischenliegender IR-reflektierender Beschichtung und einer Entspiegelungsbeschichtung auf der Außenseite des ersten oder der Außenseite des ersten und des zweiten scheibenförmigen Elements ausgebildet ist. Als Anzeigevorrichtungen kommen insbesondere Flüssigkristall- z. B. TFT-LCD-Anzeigevorrichtungen, aber auch OLED-, LED-, Plasma-Anzeigevorrichtungen in Betracht. Besonders bevorzugt ist eine Anwendung bei Outdooranzeigeeinrichtungen auf die direktes Sonnenlicht einfällt.

Neben der Verwendung in Anzeigevorrichtungen ist auch eine Verwendung als Bildverglasung oder im Bereich der Architektur, insbesondere als Vorhangfassade, oder in Automobilverglasungen möglich. Bei der Verwendung als Vorhangfassade kann mit der Einrichtung vermieden werden, dass Hitze in eine Gebäudehülle eindringt. Mit der Erfindung kann somit Sonnenhitze effektiv aus einem Gebäude ferngehalten werden. Als Windschutzscheibe findet die erfindungsgemäße Einrichtung bzw. Scheibe vor allem als zumindest einseitig entspiegelte Windschutzscheibe Verwendung. Eine derartige Einrichtung weist somit immer wenigstens eine Entspiegelungsschicht auf.

Die Erfindung wird nachfolgend anhand der beigefügten Zeichnungen näher erläutert, welche die Erfindung nicht beschränken sollen. Im Einzelnen zeigt:
- Fig.1 a-b: den prinzipiellen Aufbau einer erfindungsgemäßen Einrichtung mit IR-reflektierender Beschichtung; Figur 1a zeigt eine Draufsicht auf eine erfindungsgemäße Einrichtung 1 und Figur 1b einen Schnitt entlang der Linie A - A
- Fig.2: eine Flüssigkristallanzeigevorrichtung mit einer erfindungsgemäßen Einrichtung gemäß Fig. 1a-1b;
- Fig. 3a -b: die Reflexions- und Transmissionskurven der erfindungsgemäßen Einrichtung mit IR-Beschichtung gemäß Fig. 1a-1b in Abhängigkeit von der Wellenlänge;
- Fig. 4a-b: den prinzipiellen Aufbau einer erfindungsgemäßen Einrichtung mit IR-reflektierender Beschichtung in der Ausführung als projiziertkapazitiver Touchscreen.

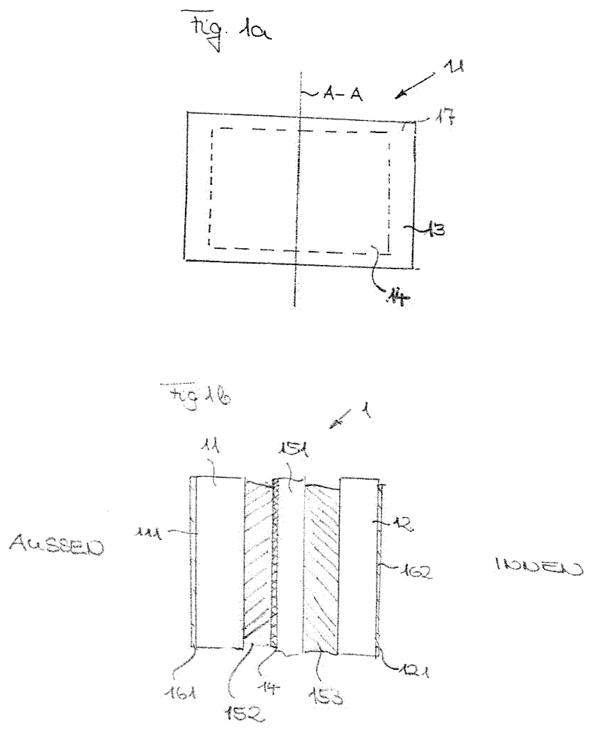

Die Draufsicht gemäß Figur 1a zeigt das erste scheibenförmige Element 11. Das erste scheibenförmige Element 11 umfasst einen Rand 13, der nicht mit einer IR-reflektierenden Beschichtung 14 versehen ist. Der Aufbau des Systems bzw. der Einrichtung 1, die auch als Verbundglaselement bezeichnet wird, aus zwei scheibenförmigen Elementen 11, 12 ist deutlicher aus der Schnittansicht entlang der Linie A-A gemäß Figur 1b zu entnehmen. Wiederum bezeichnet 11 das erste scheibenförmige Element. Die IR-reflektierende Beschichtung 14 ist auf eine Folie 151, die eine Polymerfolieoder ein Glassubstrat sein kann, aufgebracht und zwischen das erste scheibenförmige Element 11 und das zweite scheibenförmige Element 12 eingebracht. Die hier verwendete IR-reflektierende Beschichtung 14 die auf die Folie 151 aufgebracht ist, wird beispielsweise unter der Bezeichnung XIR-Folie von der Firma Southwall, Palo Alto, California, USA angeboten. Beispielsweise kann eine solche IR-reflektierende Beschichtung aus einem Schichtaufbau aus mehr als 15 Einzelschichten bestehen, welche auf einer PET-Folie mit 60 µm Dicke aufgetragen sind. Die IR-reflektierende Beschichtung bildet zusammen mit den beiden scheibenförmigen Elementen einen Verbund bzw. eine Verbundscheibe. Um den Verbund auszubilden, wird in den Zwischenraum zwischen den beiden Scheiben 11 und 12 wenigstens zwei Laminierfolien insbesondere Polymerfolien, wie PVB-Folien, eingebracht. Beide Laminierfolien 152 und 153 verbinden fest die Folie 151 und die darauf aufgetragene IR-reflektierende Schicht 14 mit dem ersten scheibenförmigen Element 11 auf der nach Außen AUSSEN zeigenden Seite und dem zweiten scheibenförmigen Element 12 auf der nach Innen INNEN weisenden Seite des Elements 1. Im Gegensatz zu einem Isolierglas-Verbund bei dem zwei Scheiben durch einen Zwischenraum mit einem gasförmigen Medium voneinander getrennt angeordnet sind, liegen bei der erfindungsgemäßem Einrichtung die scheibenförmigen Elemente 11, 12 über das Füllmaterial bestehend aus den beiden Laminierfolien 152, 153, die IR-Reflexionsbeschichtung 14 aufnehmende Folie 151 direkt aneinander an, ergebend ein Verbundglaselement. Das Füllmaterial ist dadurch gekennzeichnet, dass es eine optische Brechzahl im sichtbaren Bereich hat, die an die scheibenförmigen Elemente 11 und 12 angepasst ist, um störende optische Reflexionen im Innenbereich des Gesamtverbundes zu minimieren. Die optische Brechzahl des Füllmaterials (gemessen bei 550nm) sollte sich um nicht mehr als +-0,2, vorzugsweise +-0,1 von der Brechzahl der Elemente 11 und 12 unterscheiden.

Wie aus der Schnittansicht gemäß Figur 1b ersichtlich ist, ist der Rand 13 sowohl des ersten scheibenförmigen Elementes 11 als auch des zweiten scheibenförmigen Elementes 12 nicht mit einem Füllmaterial oder einer IR-reflektierenden Beschichtung 14 versehen. In den Randbereich wurde eine Dichtmasse 17 eingebracht, die verhindert, dass durch Diffusion entlang des Füllmaterials, bspw. einer Folie, Feuchtigkeit in den Zwischenraum zwischen dem ersten scheibenförmigen Element und dem zweiten scheibenförmigen Element eindringt und so die zwischen dem ersten und dem zweiten scheibenförmigen Element liegende IR-reflektierende Beschichtung 14, vor Korrosion geschützt wird. Die IR-reflektierende Beschichtung 14 enthält bevorzugt zwei Silberschichten und ist auf der Folie 151, insbesondere der Polymerfolie aufgetragen. Angegeben sind auch die Transmission im Sichtbaren Spektralbereichs Tᵥᵢₛ, die im Infraroten Spektralbereich T (IR), die Reflexion Rᵥᵢₛ und die IR-Sonnenreflektivität von auf die Außenseite AUSSEN einfallendem Sonnenlicht. Um im sichtbaren Wellenlängenbereich eine hohe Transmission Tᵥᵢₛ, bevorzugt Tᵥᵢₛ von größer 50% und eine niedrige Reflexion Rᵥᵢₛ, bevorzugt Rᵥᵢₛ kleiner gleich 4%, insbesondere kleiner gleich 3% zu erreichen, können oxidische und/oder leitfähig oxidische Anpassungsschichten vorgesehen werde. Diese Anpassschichten können ober- und/oder unterhalb der metallischen Schichten liegen, als auch zwischen ihnen angebracht werden, so dass sie die Reflektivität Rᵥᵢₛ innerhalb der Einrichtung 1 bzw. des Verbundglaselementes minimieren. Im Rahmen der Auflösung der Zeichnung können diese Schichten, deren Dicken sich bevorzugt zwischen 10 nm und 500 nm bewegen, nicht von der IR reflektierende Beschichtung 14 unterschieden werden. Das System aus optischen Anpasschichten und IR reflektierenden Schichten bildet ein optisch wirksames Gesamtsystem, das insgesamt so aufgebaut wird, um die zuvor niedergelegten Vorgaben, beispielsweise in Bezug auf Transmission und Reflektivität zu erfüllen.

Diese Schichten setzen sich durch Diffusionssperrschichten zum Schutz des Silbers der IR-reflektierenden Beschichtung 14 sowie Anpassungsschichten aus anderen z. B. Oxiden oder Nitriden zusammen, deren Brechzahlsprünge und Schichtdicken dann als Anpassungsschicht ausgelegt werden. Alternativ kann die Beschichtung 14 auch links von der Folie 151 im Verbund liegen, ohne dass die Funktionsfähigkeit eingeschränkt wird.

Die Ausbildung einer IR-reflektierenden Beschichtung, insbesondere einer low-E-Beschichtung auf der Basis von Silberschichten ist in Hans-Joachim Gläser, "Dünnfilmtechnologie auf Flachglas", S. 167 - 171, deren Offenbarungsgehalt vollumfänglich in die vorliegende Anmeldung mit aufgenommen wird, eingehend beschrieben. Während auch andere Metalle wie Gold oder Aluminium als IR-reflektierende Beschichtungen möglich sind, ist Silber wegen seiner guten Farbwirkung (Reflektivitätsspektrum) bevorzugt.

Bei einer Verwendung der Einrichtung insbesondere im Außenbereich für Anzeigevorrichtungen ist es vorteilhaft, wenn zur Erhöhung des Kontrastes bei Einstrahlung von direktem Sonnenlicht die Außenseite AUSSEN, das heißt die zur Luft gerichtete Seite 111 der Einrichtung mit einer Entspiegelungsbeschichtung beziehungsweise einer Antireflexbeschichtung 161 und/oder einer Licht streuenden Anti-Glare-Oberfläche versehen ist. Weiterhin kann, wie in Fig. 1b dargestellt, auch die Innenseite INNEN, das heißt die zum hinteren Aufbau der Anzeigevorrichtung gerichtete Seite 121 der Einrichtung, mit einer Entspiegelungsbeschichtung beziehungsweise einer Antireflexbeschichtung 162 versehen sein. Bei einer Konfiguration mit "optical Bonding" entfällt die rückseitige Anireflexschicht 162, und wird durch einen brechzahlangepassten Klebstoff direkt mit dem Display verbunden. In diesem Fall kann das rückseitige Element 12 mit dem Füllmaterial 153 entfallen und wird durch die vorderste Scheibe des angrenzenden Displays ersetzt. In diesem Fall ist das Füllmaterial 153 die optische Bondigschicht, und das Element 162 ist die vorderseitige Verscheibung eines Displays. Diese vorderseitige Verscheibung 162 enthält dann abhängig von der Displaytechnologie ggf. eine Polarisationseinrichtung, um die Funktionsweise des Displays zu gewährleisten.

In einer fortgebildeten Ausführungsform ist es auch möglich, dass die Entspiegelungsschicht 162 auf der Innenseite entfällt und durch ein optisch angepasstes Füllmedium ersetzt wird, das den Zwischenraum zwischen dem scheibenförmigen Element 12 und der Anzeigeeinrichtung ausfüllt. In der weitergebildeten Ausführungsform kann das zweite scheibenförmige Element 12 auch die Vorderseite des Displays darstellen.

Als Entspiegelungsbeschichtung oder Antireflexbeschichtung, kommen beispielsweise mit Sol-Gel-Verfahren, Sputter- oder Aufdampfverfahren hergestellte Entspiegelungsbeschichtungen zum Einsatz. Nachfolgend sollen zwei Ausführungsbeispiele für derartige Entspiegelungs- beziehungsweise Antireflexbeschichtungen angegeben werden:

### Beispiel 1:

Einseitige Antireflexbeschichtung, hergestellt nach dem Sol-Gel-Verfahren:

Die Beschichtung besteht aus jeweils drei Einzelschichten und besitzt die Struktur: Substrat + M + T + S. Die mit T gekennzeichnete Einzelschicht enthält Titandioxid TiO₂, die mit S gekennzeichnete Einzelschicht enthält Siliziumdioxid SiO₂ und die mit M gekennzeichnete Einzelschicht wird jeweils aus S- und T-Mischlösungen gezogen. Das Glassubstrat wird vor der Beschichtung sorgfältig gereinigt. Die Tauchlösungen werden jeweils in auf 28° C klimatisierten Räumen bei einer Luftfeuchtigkeit von 5 - 10 g/m3 mittels des Verfahrens der Tauchbeschichtung aufgetragen.

Die Ziehgeschwindigkeiten beim Herausziehen der Gläser aus der Tauchlösung betragen für die Einzelschichten M/T/S ca. 275/330/288 mm/min und hängen von der Konzentration der Feststoffe in der Lösung, dem Lösungsmittel, im Allgemeinen Ethanol, den Temperaturen und der Viskosität der Lösung ab. Auf das Ziehen einer jeden Gel-Schicht folgt ein Ausheizprozess an Luft. Die Ausheiztemperaturen und Ausheizzeiten betragen 180° C/2min nach Herstellung der ersten und zweiten Gel-Schicht sowie 440° C/60min nach der Herstellung der dritten Gel-Schicht. Im Falle der T-Schichten setzt sich die Tauchlösung (pro Liter) zusammen aus: 68 ml Titann-Butylat, 918 ml Ethanol (abs), 5 ml Acetylaceton und 9 ml Ethyl-Butylacetat. Die Tauchlösung zur Herstellung der S-Schicht enthält: 125 ml Kieselsäure Methylester, 400 ml Ethanol (abs), 75 ml H2O (dest.), 7,5 ml Essigsäure und wird nach einer Ruhezeit von ca. 12 Stunden mit 393 ml Ethanol (abs) verdünnt. Die Beschichtungslösungen zur Herstellung der Oxide mit mittlerem Brechungsindex werden durch Mischung der S + T-Lösungen präpariert. Die mit M gekennzeichnete Schicht wird aus einer Tauchlösung mit einem Siliziumdioxid-Gehalt von 5,5 g/l und einem Titandioxid-Gehalt von 2,8 g/l gezogen. Der angewandte nasschemische Sol-Gel-Prozess erlaubt als Tauchverfahren die wirtschaftliche Beschichtung großer Flächen, wobei zwei Scheiben vor dem Tauchvorgang miteinander verklebt werden, damit die notwendige einseitige Entspiegelungswirkung erzielt wird. Der Kleber ist so gewählt, dass er bei 440° C innerhalb der oben beschriebenen Einbrennzeit verbrennt, so dass die Scheiben den Prozess getrennt verlassen.

### Beispiel 2:

Einseitige Antireflexbeschichtung, hergestellt nach dem Sputterverfahren:
Die Beschichtung wird in einer Durchlaufanlage mit einem MF Sputterprozess durch Magnetronsputtern beschichtet, wobei das Substrat auf einem sogenannten Carrier positioniert und auf diesem durch die Sputteranlage transportiert wird. Innerhalb der Beschichtungsanlage wird das Substrat zunächst zur "Entwässerung" der Oberflächen auf ca. 150° C vorerwärmt. Anschließend wird ein Antireflex-System (als Beispiel bestehend aus vier Schichten) wie folgt hergestellt:
   A) Sputtern einer hochbrechenden Schicht 1 mit einem Vorschub von 1,7 m/min, wobei der Carrier vor der Sputterquelle pendelt und währenddessen eine Schicht von 30 nm Dicke abgeschieden wird. Die Schichtherstellung erfolgt durch Zugabe von Argon und Reaktivgas unter Regelung des Reaktivgases auf eine Plasmaimpedanz. Der Prozessdruck wird insbesondere durch die Menge an Argon und Sauerstoff bestimmt, welcher zu typischen Prozessdrücken im Bereich zwischen 1*E-3 und 1*E-2 mbar führt. Die Abscheidung im Plasma erfolgt über eine Pulsung.
   B) Sputtern einer niedrigbrechenden Schicht 2 mit einem Vorschub von 2,14 m/min. Hierbei wird eine Schicht der Dicke 30,5 nm hergestellt. Die Schichtherstellung erfolgt entsprechend der Abscheidung unter Schicht 1.
   C) Sputtern einer hochbrechenden Schicht entsprechend Schicht 1. Hier wird bei einem Vorschub von 0,9 m/min eine Schicht der Dicke 54 nm hergestellt.
   D) Sputtern einer niedrigbrechenden Schicht gemäß Schicht 2. Bei einem Vorschub von 0,63 m/min wird eine Schicht der Dicke 103 nm hergestellt. Anschließend wird das beschichtete Substrat mit dem Carrier über eine Transferkammer ausgeschleust.

Mit den Entspiegelungs- beziehungsweise Antireflexbeschichtungen, wie oben beschrieben, kann ein Kontrast, der als Tᵥᵢₛ/Rᵥᵢₛ definiert ist, im Bereich 10 bis 60, bevorzugt 20 bis 60, insbesondere 40 bis 50 bei Normlicht erreicht werden, wobei bei nicht entspiegelten Scheiben die Kontrastwerte geringer als 7 sind. Rᵥᵢₛ bezeichnet den Reflexionsgrad einer Schicht bei Normlicht D65, Tᵥᵢₛ den Transmissionsgrad, d. h. den Reflexionsgrad bzw. Transmissionsgrad im sichtbaren Wellenlängenbereich von 350 bis 780 nm.

Bei dem in Figur 1a-1b gezeigten Beispiel sind die Laminierfolien 151, 152 in gleicher Dicke von jeweils ca. 0,76 mm ausgeführt, zwischen denen sich die Folie mit der IR-reflektierenden Beschichtung befindet, die durch die Laminierfolien mit dem Glas verbunden wird. In einer alternativen Ausführung können diese jedoch auch asymmetrisch ausgeführt sein. So ist die Laminierfolie 151, welche das Sonnenlicht vor seiner Reflexion auf der IR-reflektierenden Schicht 14 durchläuft, dünner ausgestaltet mit einer Dicke von beispielsweise 380 µm oder 100 µm. Die Laminierfolie 152 hat dagegen eine größere Schichtdicke von beispielsweise 700 µm. Die dünnere Folienstärke der Laminierfolie 151 hat den Vorteil, dass weniger Energie des Sonnenlichts absorbiert wird und damit ein geringerer Wärmeeintrag in das System bzw. die Einrichtung 1 erfolgt.

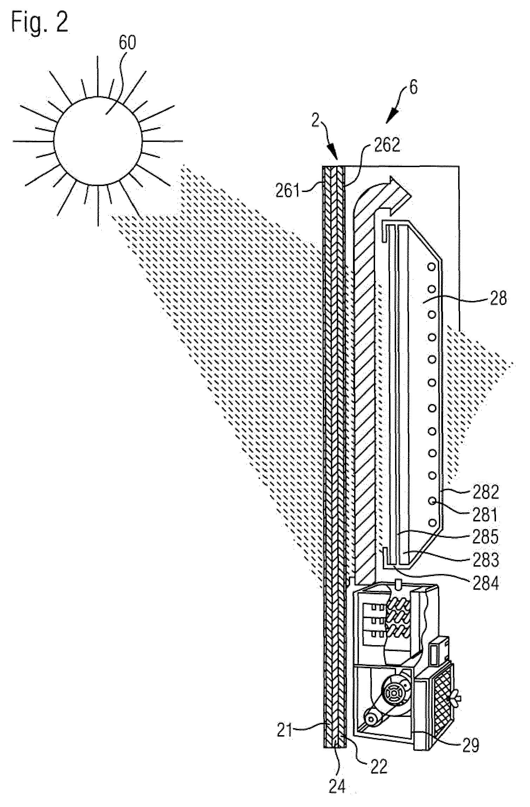

In Figur 2 ist eine Anzeigevorrichtung 6 mit einer erfindungsgemäßen Einrichtung 2 als Vorsatzscheibe für ein Display, hier eine Flüssigkristallanzeige 28 dargestellt. Wie in Figur 1a - 1b gezeigt, ist die erfindungsgemäße Einrichtung 2 mit einem ersten scheibenförmigen Element 21 und einem zweiten scheibenförmigen Element 22 sowie einer dazwischenliegenden IR-reflektierenden Schicht 24 und einer auf die Außenseite der ersten Scheibe bzw. des ersten scheibenförmigen Elementes 21 und einer auf die Außenseite der zweiten Scheibe bzw. des zweiten scheibenförmigen Elementes 22 aufgebrachten Antireflex- bzw. Entspiegelungsbeschichtung 261, 262 versehen. Die hinter der als Vorsatzscheibe ausgebildeten Einrichtung 2 liegende Flüssigkristallanzeige 28 umfasst ohne Beschränkung hierauf einen zwischen zwei Scheiben 284, 285 eingebrachten Flüssigkristall 283 mit Leuchtmitteln 281. Die gesamte Flüssigkristallanzeige 28 ist in ein Gehäuse 282 integriert. Die Flüssigkristallanzeige 28 ist nur eine mögliche Anzeige, andere mögliche Anzeigen umfassen ansteuerbare LED oder auch OLED. Obwohl eine Flüssigkristallanzeige angegeben ist, ist die Erfindung hierauf nicht beschränkt. Gleiche Bauteile wie in Figur 1 sind mit ähnlichen Bezugsziffern belegt, die scheibenförmigen Elemente und die IR reflektierende Schicht mit um 10 erhöhten Bezugsziffern, die Antireflex- und Entspiegelungsschichten mit um 200 erhöhte Bezugsziffern. Die Laminierfolien aus Figur 1 sind bei der Einrichtung 2, in Figur 2, die in der Regel gleiche zur Einrichtung 1 in Figur 1 aufgebaut ist nicht explizit dargestellt, aber obwohl nicht dargestellt in der Regel vorhanden.

Die erfindungsgemäße Einrichtung 2 als Vorsatzscheibe verhindert weitgehend, dass Licht der Sonne 60 den Zwischenraum zwischen der Vorsatzscheibe 2 und der Flüssigkristallanzeige 28 aufheizt. Nichts desto trotz ist es aber aufgrund der eigenen Wärmeentwicklung der Flüssigkristallanzeige 28 je nach Ausführung der Anzeigevorrichtung notwendig, diese aktiv beispielsweise wie hier dargestellt, mit einer Kühleinrichtung 29 zu kühlen. Die Kühleinrichtung 29 kann jedoch wesentlich kleiner dimensioniert werden als im Stand der Technik, da ein kleinerer Wärmeeintrag aufgrund der Sonnenbestrahlung zwischen die Scheibe und die Flüssigkristallanzeige nicht stattfindet.

Für den optischen Kontrast der gesamten Anzeigeeinrichtung ist es wichtig zu beachten, dass das Display selber nicht zu viel Reflexion aufweist, da sonst der Vorteil der Entspiegelungswirkung der in der Erfindung beschriebenen Frontscheibe nicht voll zum Tragen kommt.

Bei anderen, insbesondere kleineren Anzeigevorrichtungen, kann in einer alternativen Ausführung der Erfindung die Einrichtung 2 als Vorsatzscheibe auch direkt beispielsweise auf die Scheibe 284 der Anzeigevorrichtung geklebt oder laminiert werden. Dies bezeichnet man als "optisches Bonding". Die Einrichtung 2 als Vorsatzscheibe kann auch direkt anstelle der Scheibe 284 als Begrenzung zum Flüssigkristall 283 eingesetzt werden, was einen Vorteil bezüglich Baugröße und Gewicht bringt.

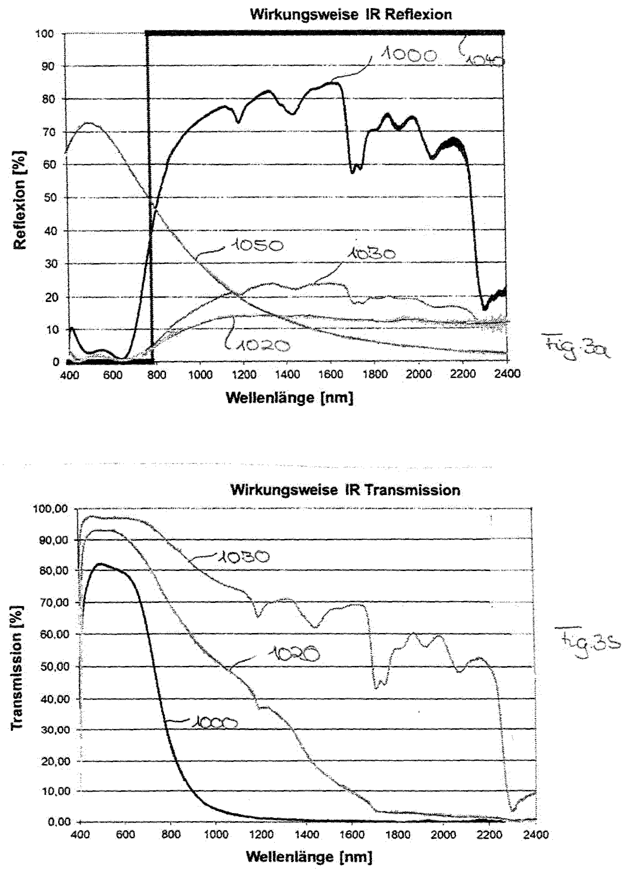

Die Figur 3a zeigt die Reflektivität für Einrichtungen mit unterschiedlichen Schichtsystemen über einer Wellenlänge von 300 nm bis 2500 nm.

In Figur 3b sind die zugehörigen Transmissionswerte für die gleichen Schichtsysteme mit gleicher Bezifferung dargestellt.

Es bezeichnet die Bezugsziffer 1000 ein System aus einer silberbasierten Beschichtung als IR-Reflexionsschicht der Firma Southwall, basierend auf dem Produkt XIR70 und einer IR-reflektierenden Folie Siplex Solar Control mit einer Entspiegelung 1020, sowie als Vergleich eine Antireflexbeschichtung mit Bezugsziffer 1030 ohne IR-reflektierende Beschichtung (CONTURAN der Firma SCHOTT). Zusätzlich sind in der Figur 3a noch die Kurve eines ideal reflektierenden IR-Spiegels 1040 abgebildet, der alle Wellenlängen oberhalb von 780 nm, der Grenze des sichtbaren Lichtes, reflektiert und die idealisierte Intensitätsverteilung des Sonnenspektrums 1050 gezeigt, das als Planck'scher Strahler mit einer Oberflächentemperatur von 5762K angenähert ist. Hierbei wurden Absorptionsbanden zur Vereinfachung im Spektrum vernachlässigt. Bei allen Einrichtungen handelt es sich um Verbundsystem mit erstem und zweitem scheibenförmigen Element und den entsprechenden Beschichtungen. Die in Tabelle 1 angegebenen Daten für die Reflexion Rᵥᵢₛ und Transmission Tᵥᵢₛ im sichtbaren Wellenlängenbereich sowie die IR-Transmission T (IR) und die IR-Sonnenreflektivität beziehen sich auf die Gesamtsysteme, d. h. das Verbundglaselement bestehend aus zwei scheibenförmigen Elementen mit den entsprechenden Beschichtungen. Diese Systeme enthalten in jedem Fall zwei Entspiegelungsschichten 161,162 gemäß Figur 1, weisen jedoch unterschiedliche IR Reflexionsschichten auf. Diesbezüglich wird auf Figur 1b verwiesen.

In Tabelle 1 sind die Daten für die unterschiedlichen Schichtsysteme, die in den Figuren 3a und 3b gezeigt werden angegeben.

| System (Scheibe 1/IR-Schicht/Scheibe2) | Rᵥᵢₛ (D65) | Tᵥᵢₛ (D65) | T (IR) 780 - 2000 nm | IR Sonnenreflexion |
|---|---|---|---|---|
| CONTURAN Entspiegelungsbeschichtung (1030) | 1% | 96% | 67% | 17% |
| IR-reflektierende Folie Siplex Solar + Entspiegelungsbeschichtung (1020) | 1,5% | 92% | 28% | 11% |
| Silberbasierte IR-Reflexionsschicht Southwall XIR70-Folie +Entspiegelungsschicht (1000) | 1,6% | 79% | 3,5% | 68% |

Wie aus Tabelle 1 hervorgeht, tritt der höchste Kontrast, nämlich von Tᵥᵢₛ/Rᵥᵢₛ= 50, mit der höchsten Transmission Tᵥᵢₛ, nämlich von 79%, bei der höchsten IR-Sonnenreflexion von 68% und niedriger IR-Transmission T(IR) von nur 3,5% für die erfindungsgemäße Einrichtung aus zwei Scheiben mit dazwischenliegenden silberbasierte IR-Reflexionssystem in Kombination mit einer Entspiegelungsbeschichtung auf die ersten und/oder zweiten Scheiben des Verbundsystems auf.

Mit Hilfe eines genäherten Sonnenspektrum, das durch einen Planck'schen Strahler mit T = 5762K gut dargestellt werden kann, kann man ableiten, wie viel Energie des Sonnenlichtes in den IR-Bereich oberhalb 780 nm bis 2500 nm entfällt: so liegt ca. 45% der Sonnenenergie in diesem Bereich und ca. 55% liegen im Bereich 350 nm - 780 nm. Hierbei wurden UV-Anteile unterhalb 350nm vernachlässigt, da die Transmission hier durch das feste bzw. flüssige Füllmaterial bereits deutlich herabgesetzt ist. Wellenlängen oberhalb von 2500 nm wurden ebenfalls nicht berücksichtigt, da Glas oberhalb 2500 nm selbst stark absorbiert.

In Figur 3a ist neben dem genäherten Sonnenspektrum 1050 auch ein idealer IR-Spiegel 1040 dargestellt, der unterhalb 780nm im sichtbaren Bereich keine Reflexion aufweist und oberhalb 780nm 100% Reflektivität zeigt. Dieses Idealdesign des Spiegels ermöglicht eine Reflexion von ungefähr 45% der relevanten Sonnenstrahlung, ohne den sichtbaren Bereich zu beeinträchtigen. Die Zahlenwerte der IR-Reflexion werden in dieser Anmeldung relativ zu diesem idealen IR-Spiegel angegeben.

Wenn man die spektralen Reflektivitäten der Beispiele aus Figur 3a mit der relativen Intensität des genäherten Sonnenspektrums faltet, das als Planck'scher Strahler mit T=5762 K genähert ist, so kann man ermitteln, wieviel Strahlung der Sonne im IR-Bereich oberhalb 780 nm reflektiert wird. Dieser Wert, bezogen auf die Reflektivität des idealisierten IR-Spiegels mit 100% Reflexion oberhalb 780 nm, wird in dieser Anmeldung als IR-Sonnenreflektivität definiert.

Aus Tabelle 1 geht hervor, dass mittels der hier beschriebenen silberbasierten IR-Reflexionsschicht 30% der Energie des gesamten Sonnenspektrums reflektiert werden kann, was einer IR-Sonnenreflektivität von 68% gegenüber dem idealen Spiegel mit der Kurve 1040 entspricht, während mit einer SIPLEX-Folie, die der Kurve 1020 entspricht, nur 5% möglich sind, was einer IR-Sonnenreflektivität von 11 % gegenüber dem idealen Spiegel entspricht.

Einem Fachmann ist klar, dass in praktischen Ausführungen noch Teile des sichtbaren Spektrums der Kurven 1000,1100, 1040 und 1050 zur IR-Reflexion genutzt werden können, da das Auge an den Rändern des sichtbaren Bereiches hin immer unempfindlicher wirkt. Zum Nachweis der Wirksamkeit wurde die Vereinfachung mittels idealem Spiegel eingeführt.

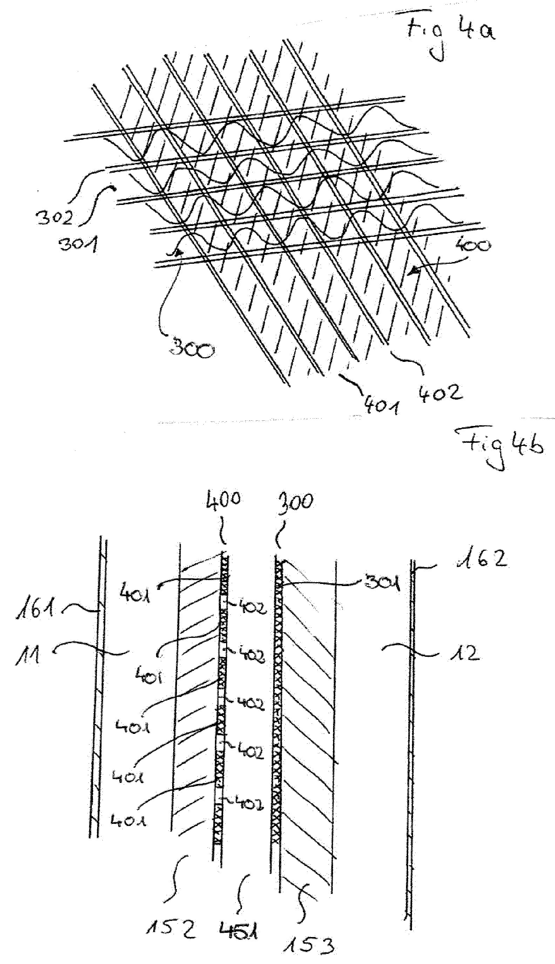

Figuren 4a bis 4b zeigen den prinzipiellen Aufbau einer erfindungsgemäßen Einrichtung mit IR-reflektierender Beschichtung in der Ausführung als projiziertkapazitiver Touchscreen. Das Besondere an der in den Figuren 4a - 4b dargestellten Ausführungsform ist, dass die leitfähigen Schichten gleichzeitig auch die IR-reflektierenden Schichten sind.

Figur 4a und Figur 4b zeigen den vereinfachten Aufbau einer Einrichtung zur Detektion einen Touch Signales. Dabei sind zwei leitfähige, strukturierte Schichten 400 und 300 durch eine isolierende Zwischenschicht 451 voneinander getrennt, so dass durch die orthogonal zueinander versetzte Strukturierung der Schichten 400 und 300 eine Positionsbestimmung des Signals auf der Oberfläche möglich ist. Die Isolierschicht 451 besteht in einer bevorzugten Ausführungsform aus demselben Material wie die Isoliersicht 151 des Aufbaues gemäß den Fig. 1 - 3. Die Strukturierung der Schicht 300 ist so vorgenommen, dass in x-Richtungen die Leiterbahn 301 durch eine nicht leitfähige Unterbrechung 302 von der Nachbarleiterbahn getrennt ist. Derartige Unterbrechungen können beispielsweise durch lithographische Ätzverfahren oder Laserstrukturierung vorgenommen werden. Analog dazu ist der Aufbau in y-Richtung, bei dem die Leiterbahnen 401 durch nicht leitfähige Bereiche 402 getrennt sind. Die beiden strukturiert leitfähigen Bereiche 300 und 400 werden elektronisch getrennt ausgewertet, wobei die Änderung der Kapazität gemessen wird, die ein Kondensator, gebildet aus den leitfähigen Schichten 301 und 401 mit einer Isolierschicht 451, aufweist. Die Zeichnungen der Fig. 4a und 4b sind stark vereinfacht dargestellt. Das Isolationsmaterial bzw. die Isolierschicht 451 ist nicht notwendigerweise eine Polymerfolie, wie z. B. in Fig. 1b dargestellt. Das Isolationsmaterial 451 kann auch ein Glas sein. Wie zuvor beschrieben, trägt das Isolationsmaterial 451 die IR-reflektierende Beschichtung. Vorliegend sind die leitfähigen Schichten 400, 300 in Fig. 4b gleichzeitig die IR-reflektierenden Schichten. Die Scheiben 11, 12, die das Isolationsmaterial einschließen, sind ober- und unterhalb der Laminierfolien 152, 153 angeordnet.

Fig. 4b stellt denselben Aufbau wie Fig. 4a dar, nur als Querschnitt. Dies soll verdeutlichen, dass zwischen den strukturierten Schichten 400 und 300 mit Leiterbahnen 301, 401 eine nichtleitende Schicht 451, die als Folie ausgebildet sein kann, liegt. Die in Fig. 4a dargestellten Unterbrechungen der Schichten 400 und 300 sind in Fig. 4a als Unterbrechungen in der Leiterbahn 401 dargestellt, wobei bei diesem Schnitt die Richtung so gewählt wurde, dass Leiterbahn 301 durchgängig ist und die Leiterbahn 401 nicht leitfähige Unterbrechungen 402 umfasst. Abhängig vom Schnittwinkel des Querschnitts kann dies natürlich variieren.

Dem Fachmann ist geläufig, wie man derartige Strukturen aufbringt. Wie zuvor beschrieben, bilden die leitenden Schichten 400, 300 auf dem Isolationsmaterial 451 selbst die IR-reflektierende Beschichtung aus. Die IR-reflektierenden Schichten umfassen beispielsweise Silber und sind deswegen leitfähig. Durch die sehr geringe Dicke der Silberschichten von weniger als 10 nm weisen die Silberschichten eine hohe optische Transmission auf. Dies wird aus den optischen Daten in Tabelle 1 sichtbar. So ist die Absorption in den Silberschichten dafür verantwortlich, dass im Ausführungsbeispiel "silberbasierte IR-Reflexionsschicht" nur eine Transmission von 79% erreicht wird, im Gegensatz zu dem Ausführungsbeispiel mit der nicht absorbierenden CONTURAN-Schichten (Transmission: 96%). Trotz der niedrigen Transmission im Falle der silberbasierten IR-Reflexionsschichten im sichtbaren Wellenlängenbereich (VIS-Licht) wird noch ausreichend optische Strahlung transmittiert, so dass man durch das Gesamtelement noch hindurchsehen kann. Da zwei leitfähige Schichten 400, 300 vorgesehen sind, umfasst die Ausgestaltung in Figur 4b auch zwei IR-reflektierende Beschichtungen auf dem Isolationsmaterial 451-Vorteilhaft im Sinne der Erfindung ist, dass die nicht leitfähigen Bereiche der Schichten 402 und 302 flächenmäßig geringer als die leitfähigen Bereiche 401 und 301 sind, da im Bereich 302 und 402 wegen der Ausbildung der leitfähigen Schichten 300, 400 als IR-reflektierende Schichten die IR Strahlung auf das Display fallen kann. Durch die orthogonal angeordneten Unterbrechungen 302 und 402 sind jedoch nur die Kreuzungspunkte frei von der leitfähigen und damit der IR-reflektierenden Beschichtung, und damit flächenmäßig gering. Während in der dargestellten Ausführungsform die IR-reflektierenden und leitenden Schicht auf gegenüberliegenden Seiten des Isolationsmaterials 451 angeordnet sind, ist es in einer alternativen Ausgestaltung der Erfindung auch möglich, dass die beiden orthogonal zueinander angeordneten Schichten 300 und 400 auch auf derselben Seite des Isolationsmaterials 451 angeordnet werden können. In einem solchen Fall muss aber zwischen diesen beiden Schichten ein weiteres Isolationsmaterial eingebracht werden, um eine Leitfähigkeit zwischen den Schichten 300 und 400 zu unterbinden.

Die Dicke der Silberschichten mit einem möglichst hohen Silberanteil, die als IR-reflektierende Beschichtung und als leitende Beschichtung verwandt werden, beträgt bevorzugt weniger als 20 nm. Die untere Grenze für derartige Schichten ist eine Dicke von 1 nm. Der bevorzugte Bereich der Dicke der Silber enthaltenden leitenden und IR-reflektierenden Schichten liegt somit zwischen 1 nm und 20 nm, bevorzugt zwischen 1 nm und 10 nm.

Durch das erfindungsgemäße System einer Verbundscheibe mit IR-reflektierender Beschichtung, wie zuvor beschrieben, ist es erstmals möglich, einen hohen optischen Kontrast im sichtbaren Wellenlängenbereich insbesondere bei einer Außenanwendung im Anzeigebereich mit einer hohen IR-Reflektivität zu verbinden und so den Wärmeeintrag aufgrund von naher IR-Sonneneinstrahlung zu vermindern. Ein weiterer Vorteil ist die einfache Herstellbarkeit, da Standard-Beschichtungsprozesse für silberbasierte Low-E Beschichtungen zur Herstellung der IR-Beschichtung eingesetzt werden können

Es versteht sich, dass die Erfindung nicht auf eine Kombination vorstehend beschriebener Merkmale beschränkt ist, sondern dass der Fachmann sämtliche Merkmale der Erfindung, soweit dies sinnvoll ist, beliebig kombinieren oder in Alleinstellung verwenden wird, ohne den Rahmen der Erfindung zu verlassen. Andere Ausführungsformen sind möglich.

Die Erfindung umfasst Aspekte die in nachfolgenden Sätzen niedergelegt Sind, die Teil der Beschreibung sind, aber keine Ansprüche gemäß J15/88:
Sätze
   1. Einrichtung (1, 2), insbesondere für Anzeigevorrichtungen (6), umfassend ein erstes scheibenförmiges Element (11, 21) und ein zweites scheibenförmiges Element (12, 22), wenigstens eine zwischen dem ersten und dem zweiten scheibenförmigen Element eingebrachte IR-reflektierende Beschichtung (14, 24) und ein zwischen dem ersten und dem zweiten scheibenförmigen Element eingebrachtes Füllmaterial, wobei das erste und das zweite scheibenförmige Element, die IR-reflektierende Beschichtung und das Füllmaterial einen Verbund ausbilden, und bevorzugt eine Entspiegelungsbeschichtung (161, 261, 262), insbesondere im sichtbaren Wellenlängenbereich, auf der Außenseite des ersten oder der Außenseite des ersten und des zweiten scheibenförmigen Elements (11, 21, 12, 22), aufgebracht ist,
      dadurch gekennzeichnet, dass
      das Füllmaterial wenigstens zwei Laminierfolien, wenigstens eine erste Laminierfolie (152) und eine zweite Laminierfolie (153) sowie wenigstens eine weiteren Folie (151, 451) umfasst, wobei wenigstens eine IR-reflektierende Beschichtung (14, 24) vorgesehen ist, wobei die
      IR-reflektierende Beschichtung auf die Folie (151, 451) aufgebracht ist, wobei die Folie (151, 451) zwischen die wenigstens erste und die zweite Laminierfolie (152, 153) eingebracht ist und die IR-Sonnenreflektivität im Wellenlängenbereich 780 nm bis 3000 nm bevorzugt 900 nm bis 1400 nm der Einrichtung (1, 2) im Bereich 45% bis 95% liegt und die Reflektivität Rᵥᵢₛ im visuellen Wellenlängenbereich 400 nm bis 780 nm kleiner gleich 4% ist, bevorzugt im Bereich 0 % bis 4 % liegt.
   2. Einrichtung nach Satz 1,
      dadurch gekennzeichnet, dass
      die Folie (151, 451), eine organische oder eine anorganische insbesondere eine glasartige Folie oder ein organisches oder anorganisches Trägermaterial ist, bevorzugt mit einer Dicke zwischen 10µm und 5mm.
   3. Einrichtung nach einem der Sätze 1 bis 2,
      dadurch gekennzeichnet, dass
      die IR-Sonnenreflektivität der Einrichtung (1) im Bereich 50% bis 90% liegt und/oder die Reflektivität Rᵥᵢₛ im visuellen Wellenlängenbereich im Bereich kleiner gleich 3 % Ist, bevorzugt im Bereich 0 % bis 3 % liegt.
   4. Einrichtung nach einem der Sätze 1 bis 3, dadurch gekennzeichnet, dass ein Rand (13) des ersten scheibenförmigen Elementes (11) und/oder des zweiten scheibenförmigen Elementes (12) keine IR-reflektierende Beschichtung aufweist oder die IR-reflektierende Beschichtung am Rand unterbrochen ist.
   5. Einrichtung nach einem der Sätze 1 bis 4, dadurch gekennzeichnet, dass der Rand (13) des ersten scheibenförmigen Elementes und/oder ein Rand (13) des zweiten scheibenförmigen Elementes ein Dichtmaterial aufweist.
   6. Einrichtung nach einem der Sätze 1 bis 5, dadurch gekennzeichnet, dass die IR-reflektierende Beschichtung (14) eine der nachfolgenden Beschichtungen ist:
      - eine low-E-Beschichtung oder eine Sonnenschutz-Beschichtung
      - eine low-E-Beschichtung oder Sonnenschutz-Beschichtung bestehend aus einer metallisch hochleitfähigen Schicht.
      - eine low-E-Beschichtung oder Sonnenschutz-Beschichtung umfassend eines oder mehrere der nachfolgenden Metalle:
         Silber
         Gold
         Aluminium
   7. Einrichtung nach einem der Sätze 1 bis 6, dadurch gekennzeichnet, dass die IR-reflektierende Beschichtung (14) eine low-E-Beschichtung oder Sonnenschutz-Beschichtung umfasst, die mindestens zwei durch oxidische Schichten getrennte Metallschichten enthält, beinhaltend ein oder mehrere der nachfolgenden Metalle:
      Silber
      Gold
      Aluminium
   8. Einrichtung gemäß einem der Sätze 1 bis 7, dadurch gekennzeichnet, dass die Einrichtung zusätzlich zu den metallischen Schichten optische Anpassungsschichten umfasst und die Anpassungsschichten oxidische und/oder leitfähige oxidische Schichten sind und Teil des Schichtpakets der IR-Beschichtung oder getrennt von dieser auf die wenigstens eine Folie (151, 451) aufgetragen sind.
   9. Einrichtung gemäß Satz 8, dadurch gekennzeichnet, dass die optischen Anpassungsschichten derart ausgebildet sind, dass die Reflektivität Rᵥᵢₛ der Einrichtung kleiner als 4%, bevorzugt kleiner als 3% besonders bevorzugt kleiner als 2% ist.
   10. Einrichtung gemäß einem der Sätze 1 bis 9, dadurch gekennzeichnet, dass die Entspiegelungsbeschichtung (161, 162) einen Aufbau umfasst der mit nachfolgendem Auftragsverfahren aufgebracht wird:
      a) die Entspiegelungsbeschichtung ist mit Hilfe einer Flüssigtechnologie aufgebracht, wobei die mit Hilfe der Flüssigtechnologien aufgebrachte Schicht mit Hilfe einer der nachfolgenden Techniken zur Verfügung gestellt wird:
         - die Entspiegelungsbeschichtung ist mit Hilfe der Sol-Gel-Technologie aufgebracht;
         - die Entspiegelungsbeschichtung wird als Einfachinterferenzbeschichtung aus der Sol-Gel-Technologie hergestellt;
         - die Entspiegelungsbeschichtung wird als Mehrfach-Interferenzbeschichtung aus der Sol-Gel-Technologie hergestellt;
         - die Entspiegelungsbeschichtung wird als Dreifach-Interferenz-Beschichtung aus der Sol-Gel-Technologie hergestellt, wobei die erste Schicht eine Brechzahl zwischen 1,6 und 1,8 aufweist, die zweite Schicht eine Brechzahl zwischen 1,9 und 2,5 aufweist und die Brechzahl der dritten Schicht zwischen 1,4 und 1,5 liegt.
      b) die Entspiegelungsbeschichtung ist mit Hilfe einer Hochvakuumtechnologie hergestellt, wobei die mit Hilfe der Hochvakuumtechnologie aufgebrachte Schicht mit einer der nachfolgenden Techniken zur Verfügung gestellt wird:
         - die Entspiegelungsbeschichtung wird mit Hilfe einer Hochvakuumtechnologie als Mehrfach-Interferenzschichtsystem hergestellt;
         - die Entspiegelungsbeschichtung wird mit Hilfe einer Hochvakuumtechnologie als Einfachschichtsystem hergestellt;
         - die Entspiegelungsbeschichtung wird aus einem Sputterprozess unter Hochvakuum hergestellt;
         - die Entspiegelungsbeschichtung wird aus einem Aufdampfprozess unter Hochvakuum hergestellt.
      c) die Entspiegelungsbeschichtung ist mit Hilfe eines CVD-Verfahrens hergestellt, wobei die mit Hilfe eines CVD-Verfahrens aufgebrachte Schicht mit einer der nachfolgenden Techniken zur Verfügung gestellt wird:
         - die Entspiegelungsbeschichtung wird aus einem Online-CVD-Prozess hergestellt;
         - die Entspiegelungsbeschichtung wird aus einem Offline-CVD-Prozess hergestellt.
      d) die Entspiegelungsbeschichtung ist mit Hilfe eines Ätzverfahrens hergestellt, wobei die mit Hilfe eines Ätzverfahrens aufgebrachte Schicht mit einer der nachfolgenden Techniken zur Verfügung gestellt wird:
         - die Entspiegelungsbeschichtung wird mit Hilfe eines Ätzverfahrens als poröse Schicht hergestellt;
         - die Entspiegelungsbeschichtung wird mit Hilfe eines Ätzverfahrens als lichtstreuende Oberfläche hergestellt.
   11. Einrichtung nach einem der Sätze 1 bis 10, dadurch gekennzeichnet, dass die IR-reflektierende Beschichtung mit Hilfe einer Hochvakuumtechnologie hergestellt ist, wobei die mit Hilfe der Hochvakuumtechnologie aufgebrachte Schicht mit einer der nachfolgenden Techniken zur Verfügung gestellt wird:
      - die IR-reflektierende Beschichtung wird mit Hilfe einer Hochvakuumtechnologie als Mehrfach-Interferenzschichtsystem hergestellt.
      - die IR-reflektierende Beschichtung wird mit Hilfe einer Hochvakuumtechnologie als Einfachschichtsystem hergestellt;
      - die IR-reflektierende Beschichtung wird aus einem Sputterprozess unter Hochvakuum hergestellt;
      - die IR-reflektierende Beschichtung wird aus einem Aufdampfprozess unter Hochvakuum hergestellt,
   12. Einrichtung gemäß einem der Sätze 1 bis 11,
      dadurch gekennzeichnet, dass die Entspiegelungsschicht (162) auf der Innenseite entfällt und durch ein optisch angepasstes Füllmedium ersetzt wird, das den Zwischenraum zwischen dem scheibenförmigen Element (12) und der Anzeigeeinrichtung ausfüllt.
   13. Einrichtung gemäß einem der Sätze 1 bis 12, dadurch gekennzeichnet, dass das zweite scheibenförmige Element (12) die Vorderseite des Displays darstellt.
   14. Einrichtung gemäß einem der Sätze 1 bis 13, dadurch gekennzeichnet, dass die IR-reflektierende Beschichtung gleichzeitig eine elektrisch leitfähige Schicht ist, die so strukturiert ist, dass ihre Leitfähigkeit in der Schichtebene unterbrochen wird und die entstandenen Leiterbahnen dann als mindestens eine leitfähige Elektrodenstruktur innerhalb der Struktur eines kapazitiven oder resistiven Touch Sensors eingesetzt werden kann.
   15. Einrichtung gemäß Satz 14, dadurch gekennzeichnet, dass die Einrichtung weiterhin zumindest eine, bevorzugt zwei strukturierte elektrisch leitfähige transparente Schichten einer TCO-Beschichtung, bevorzugt aus einem Indiumzinnoxid umfasst.
   16. Verwendung einer Einrichtung gemäß einem der Sätze 1 bis 15 im Bereich von Anzeigevorrichtungen, insbesondere Anzeigevorrichtungen im Außenbereich, bevorzugt mit direkter Sonneneinstrahlung, insbesondere Flüssigkristallanzeigevorrichtungen oder organische LEDs, insbesondere als Vorsatzscheibe für eine Anzeigevorrichtung (6) im Außenbereich, wobei der Randbereich versiegelt ist.
      oder
      als Touchscreen oder als Bestandteil eines Touchscreens.
      oder
      in einem der nachfolgenden Bereiche:
      - im Bereich der Bildverglasung,
      - im Bereich der Architektur, insbesondere als Vorhangfassade
      - im Bereich von Glasscheiben, insbesondere als Windschutzscheibe bevorzugt für Automobile
   17. Anzeigevorrichtung umfassend eine Flüssigkristallanzeigevorrichtung (28), eine Plasma-, eine LED- oder eine organische LED Anzeigevorrichtung und eine Vorsatzscheibe dadurch gekennzeichnet, dass die Vorsatzscheibe eine Einrichtung gemäß einem der Sätze 1 bis 15 ist.
   18. Touchscreen, umfassend eine Einrichtung gemäß einem der Sätze 1 bis 15, wobei der Touchscreen als kapazitiver und/oder optischer und/oder induktiver und/oder akustischer Touchscreen ausgeführt ist.
   19. Touchscreen nach Satz 18, wobei die IR-reflektierende Beschichtung und/oder die Anpassschichten optisch derart angepasst sind, dass die Leitbahnstruktur des Touchscreens nicht oder nahezu nicht sichtbar ist.

## Patentansprüche

1. Einrichtung (1, 2), insbesondere für Anzeigevorrichtungen (6), umfassend ein erstes scheibenförmiges Element (11, 21) und ein zweites scheibenförmiges Element (12, 22), wenigstens eine zwischen dem ersten und dem zweiten scheibenförmigen Element eingebrachte IR-reflektierende Beschichtung (14, 24) und ein zwischen dem ersten und dem zweiten scheibenförmigen Element eingebrachtes Füllmaterial, wobei das erste und das zweite scheibenförmige Element, die IR-reflektierende Beschichtung und das Füllmaterial einen Verbund ausbilden, und bevorzugt eine Entspiegelungsbeschichtung (161, 261, 262), insbesondere im sichtbaren Wellenlängenbereich, auf der Außenseite des ersten oder der Außenseite des ersten und des zweiten scheibenförmigen Elements (11, 21, 12, 22), aufgebracht ist,
**dadurch gekennzeichnet, dass**
das Füllmaterial wenigstens zwei Laminierfolien, wenigstens eine erste Laminierfolie (152) und eine zweite Laminierfolie (153) sowie wenigstens eine weiteren Folie (151, 451), insbesondere eine organische oder eine anorganische insbesondere eine glasartige Folie oder ein organisches oder anorganisches Trägermaterial ist, bevorzugt mit einer Dicke zwischen 10µm und 5mm umfasst, wobei wenigstens eine IR-reflektierende Beschichtung (14, 24) vorgesehen ist, wobei die
IR-reflektierende Beschichtung auf die Folie (151, 451) aufgebracht ist, wobei die Folie (151, 451) zwischen die wenigstens erste und die zweite Laminierfolie (152, 153) eingebracht ist und die IR-Sonnenreflektivität im Wellenlängenbereich 780 nm bis 3000 nm bevorzugt 900 nm bis 1400 nm der Einrichtung (1, 2) im Bereich 45% bis 95% liegt und die Reflektivität Rᵥᵢₛ im visuellen Wellenlängenbereich 400 nm bis 780 nm kleiner gleich 4% ist, bevorzugt im Bereich 0 % bis 4 % liegt.

2. Einrichtung nach Anspruch 1,
**dadurch gekennzeichnet, dass**
die IR-Sonnenreflektivität der Einrichtung (1) im Bereich 50% bis 90% liegt und/oder die Reflektivität Rᵥᵢₛ im visuellen Wellenlängenbereich im Bereich kleiner gleich 3 % Ist, bevorzugt im Bereich 0 % bis 3 % liegt.

3. Einrichtung nach einem Ansprüche 1 bis 2, **dadurch gekennzeichnet, dass** ein Rand (13) des ersten scheibenförmigen Elementes (11) und/oder des zweiten scheibenförmigen Elementes (12) keine IR-reflektierende Beschichtung aufweist oder die IR-reflektierende Beschichtung am Rand unterbrochen ist.

4. Einrichtung nach einem der Ansprüche 1 bis 3, **dadurch gekennzeichnet, dass**
der Rand (13) des ersten scheibenförmigen Elementes und/oder ein Rand (13) des zweiten scheibenförmigen Elementes ein Dichtmaterial aufweist.

5. Einrichtung nach einem der Ansprüche 1 bis 4, **dadurch gekennzeichnet, dass**
die IR-reflektierende Beschichtung (14) eine der nachfolgenden Beschichtungen ist:
- eine low-E-Beschichtung oder eine Sonnenschutz-Beschichtung
- eine low-E-Beschichtung oder Sonnenschutz-Beschichtung bestehend aus einer metallisch hochleitfähigen Schicht.
- eine low-E-Beschichtung oder Sonnenschutz-Beschichtung umfassend eines oder mehrere der nachfolgenden Metalle:
Silber
Gold
Aluminium
- eine low-E-Beschichtung oder Sonnenschutz-Beschichtung, die mindestens zwei durch oxidische Schichten getrennte Metallschichten enthält, beinhaltend ein oder mehrere der nachfolgenden Metalle:
Silber
Gold
Aluminium

6. Einrichtung gemäß einem der Ansprüche 1 bis 5, **dadurch gekennzeichnet, dass** die Einrichtung zusätzlich zu den metallischen Schichten optische Anpassungsschichten umfasst, die derart ausgebildet sind, dass die Reflektivität Rᵥᵢₛ der Einrichtung kleiner als 4%, bevorzugt kleiner als 3% besonders bevorzugt kleiner als 2% ist und die Anpassungsschichten oxidische und/oder leitfähige oxidische Schichten sind und Teil des Schichtpakets der IR-Beschichtung oder getrennt von dieser auf die wenigstens eine Folie (151, 451) aufgetragen sind.

7. Einrichtung gemäß einem der Ansprüche 1 bis 6, **dadurch gekennzeichnet, dass** die Entspiegelungsbeschichtung (161, 162) einen Aufbau umfasst der mit nachfolgendem Auftragsverfahren aufgebracht wird:
a) die Entspiegelungsbeschichtung ist mit Hilfe einer Flüssigtechnologie aufgebracht, wobei die mit Hilfe der Flüssigtechnologien aufgebrachte Schicht mit Hilfe einer der nachfolgenden Techniken zur Verfügung gestellt wird:
- die Entspiegelungsbeschichtung ist mit Hilfe der Sol-Gel-Technologie aufgebracht;
- die Entspiegelungsbeschichtung wird als Einfachinterferenzbeschichtung aus der Sol-Gel-Technologie hergestellt;
- die Entspiegelungsbeschichtung wird als Mehrfach-Interferenzbeschichtung aus der Sol-Gel-Technologie hergestellt;
- die Entspiegelungsbeschichtung wird als Dreifach-Interferenz-Beschichtung aus der Sol-Gel-Technologie hergestellt, wobei die erste Schicht eine Brechzahl zwischen 1,6 und 1,8 aufweist, die zweite Schicht eine Brechzahl zwischen 1,9 und 2,5 aufweist und die Brechzahl der dritten Schicht zwischen 1,4 und 1,5 liegt.
b) die Entspiegelungsbeschichtung ist mit Hilfe einer Hochvakuumtechnologie hergestellt, wobei die mit Hilfe der Hochvakuumtechnologie aufgebrachte Schicht mit einer der nachfolgenden Techniken zur Verfügung gestellt wird:
- die Entspiegelungsbeschichtung wird mit Hilfe einer Hochvakuumtechnologie als Mehrfach-Interferenzschichtsystem hergestellt;
- die Entspiegelungsbeschichtung wird mit Hilfe einer Hochvakuumtechnologie als Einfachschichtsystem hergestellt;
- die Entspiegelungsbeschichtung wird aus einem Sputterprozess unter Hochvakuum hergestellt;
- die Entspiegelungsbeschichtung wird aus einem Aufdampfprozess unter Hochvakuum hergestellt.
c) die Entspiegelungsbeschichtung ist mit Hilfe eines CVD-Verfahrens hergestellt, wobei die mit Hilfe eines CVD-Verfahrens aufgebrachte Schicht mit einer der nachfolgenden Techniken zur Verfügung gestellt wird:
- die Entspiegelungsbeschichtung wird aus einem Online-CVD-Prozess hergestellt;
- die Entspiegelungsbeschichtung wird aus einem Offline-CVD-Prozess hergestellt.
d) die Entspiegelungsbeschichtung ist mit Hilfe eines Ätzverfahrens hergestellt, wobei die mit Hilfe eines Ätzverfahrens aufgebrachte Schicht mit einer der nachfolgenden Techniken zur Verfügung gestellt wird:
- die Entspiegelungsbeschichtung wird mit Hilfe eines Ätzverfahrens als poröse Schicht hergestellt;
- die Entspiegelungsbeschichtung wird mit Hilfe eines Ätzverfahrens als lichtstreuende Oberfläche hergestellt.

8. Einrichtung nach einem der Ansprüche 1 bis 7, **dadurch gekennzeichnet, dass** die IR-reflektierende Beschichtung mit Hilfe einer Hochvakuumtechnologie hergestellt ist, wobei die mit Hilfe der Hochvakuumtechnologie aufgebrachte Schicht mit einer der nachfolgenden Techniken zur Verfügung gestellt wird:
- die IR-reflektierende Beschichtung wird mit Hilfe einer Hochvakuumtechnologie als Mehrfach-Interferenzschichtsystem hergestellt.
- die IR-reflektierende Beschichtung wird mit Hilfe einer Hochvakuumtechnologie als Einfachschichtsystem hergestellt;
- die IR-reflektierende Beschichtung wird aus einem Sputterprozess unter Hochvakuum hergestellt;
- die IR-reflektierende Beschichtung wird aus einem Aufdampfprozess unter Hochvakuum hergestellt,

9. Einrichtung gemäß einem der Ansprüche 1 bis 8,
**dadurch gekennzeichnet, dass** die Entspiegelungsschicht (162) auf der Innenseite entfällt und durch ein optisch angepasstes Füllmedium ersetzt wird, das den Zwischenraum zwischen dem scheibenförmigen Element (12) und der Anzeigeeinrichtung ausfüllt.

10. Einrichtung gemäß einem der Ansprüche 1 bis 9, **dadurch gekennzeichnet, dass** das zweite scheibenförmige Element (12) die Vorderseite des Displays darstellt.

11. Einrichtung gemäß einem der Ansprüche 1 bis 10, **dadurch gekennzeichnet, dass** die IR-reflektierende Beschichtung gleichzeitig eine elektrisch leitfähige Schicht ist, die so strukturiert ist, dass ihre Leitfähigkeit in der Schichtebene unterbrochen wird und die entstandenen Leiterbahnen dann als mindestens eine leitfähige Elektrodenstruktur innerhalb der Struktur eines kapazitiven oder resistiven Touch Sensors eingesetzt werden kann und/oder die Einrichtung weiterhin zumindest eine, bevorzugt zwei strukturierte elektrisch leitfähige transparente Schichten einer TCO-Beschichtung, bevorzugt aus einem Indiumzinnoxid umfasst.

12. Verwendung einer Einrichtung gemäß einem der Ansprüche 1 bis 11 im Bereich von Anzeigevorrichtungen, insbesondere Anzeigevorrichtungen im Außenbereich, bevorzugt mit direkter Sonneneinstrahlung, insbesondere Flüssigkristallanzeigevorrichtungen oder organische LEDs, insbesondere als Vorsatzscheibe für eine Anzeigevorrichtung (6) im Außenbereich, wobei der Randbereich versiegelt ist.
oder
als Touchscreen oder als Bestandteil eines Touchscreens.
oder
in einem der nachfolgenden Bereiche:
- im Bereich der Bildverglasung,
- im Bereich der Architektur, insbesondere als Vorhangfassade
- im Bereich von Glasscheiben, insbesondere als Windschutzscheibe bevorzugt für Automobile

13. Anzeigevorrichtung umfassend eine Flüssigkristallanzeigevorrichtung (28), eine Plasma-, eine LED- oder eine organische LED Anzeigevorrichtung und eine Vorsatzscheibe **dadurch gekennzeichnet, dass** die Vorsatzscheibe eine Einrichtung gemäß einem der Ansprüche 1 bis 11 ist.

14. Touchscreen, umfassend eine Einrichtung gemäß einem der Ansprüche 1 bis 11, wobei der Touchscreen als kapazitiver und/oder optischer und/oder induktiver und/oder akustischer Touchscreen ausgeführt ist.

15. Touchscreen nach Anspruch 14, wobei die IR-reflektierende Beschichtung und/oder die Anpassschichten optisch derart angepasst sind, dass die Leitbahnstruktur des Touchscreens nicht oder nahezu nicht sichtbar ist.
